# EUROPEAN PATENT SPECIFICATION

(11) **EP 4 521 644 B1**
(45) Date of publication and mention of the grant of the patent: **08.04.2026**
(21) Application number: 24194526.0
(22) Date of filing: 14.08.2024
(51) Int. Cl.: H03K 17/567

(54) **INTEGRATED CIRCUIT INCLUDING POWER GATING SWITCH**
INTEGRIERTE SCHALTUNG MIT STROMTORSCHALTER
CIRCUIT INTÉGRÉ COMPRENANT UN COMMUTATEUR DE PORTILLONNAGE DE PUISSANCE

(30) Priority: 06.09.2023 KR 20230118551; 29.12.2023 KR 20230197638
(43) Date of publication of application: 12.03.2025
(73) Proprietor: SAMSUNG ELECTRONICS CO., LTD., Yeongtong-gu Suwon-si, Gyeonggi-do 16677 (KR)
(72) Inventor: TANG, Hoyoung, 16677 Suwon-si, Gyeonggi-do (KR); KIM, Taehyung, 16677 Suwon-si, Gyeonggi-do (KR)
(74) Representative: Kuhnen & Wacker Patent- und Rechtsanwaltsbüro PartG mbB

(56) References cited:
- US-A1- 2022 208 757

## Description

### BACKGROUND

Apparatuses and methods consistent with embodiments of the disclosure relate to integrated circuits, and more particularly, to an integrated circuit including a power gating switch, and a method of designing the integrated circuit.

US 2022/208757 A1 discloses an integrated circuit device. The integrated circuit device includes: a substrate with a first active area and a second active area spaced apart from each other in a first horizontal direction; a plurality of normal cells arranged on a first surface of the substrate; a power wiring structure arranged on a second surface of the substrate; and a power gating cell arranged on the first surface of the substrate. The power gating cell includes: a sleep control transistor arranged in the first active area; and a through via penetrating the second active area of the substrate. The power gating cell is configured to provide a virtual power voltage to the plurality of normal cells through a virtual power line based on a power voltage supplied from the power wiring structure through the through via and a power line.

Due to the need for high integration and advancement in semiconductor processes, the widths, spacing, and/or heights of wires included in an integrated circuit may decrease and the influence of parasitic components of the wires may increase. In addition, a power supply voltage of an integrated circuit may be decreased for reduced power consumption, high operating speed, etc., and thus, the influence of parasitic components of wires on the integrated circuit may become more significant. Accordingly, there has been an increased demand for a method of designing an integrated circuit that efficiently routes wires and vias.

### SUMMARY

The invention is set out in the appended claims.

The disclosure provides an integrated circuit capable of increasing routing resources and improving area efficiency by supplying power to a power gating switch by using a backside wiring layer, and a method of designing the integrated circuit.

According to an aspect of the disclosure, there is provided an integrated circuit which may include: a backside wiring layer on a back side of a substrate, the backside wiring layer including a first backside pattern and a second backside pattern isolated from each other; and a power gating switch on a front side of the substrate, the power gating switch connected to the first and second backside patterns. The power gating switch may include: a first source/drain region connected to the first backside pattern, and configured to receive a first supply voltage from the first backside pattern; a gate line structure configured to receive a power gating signal; and a second source/drain region connected to the second backside pattern, and configured to receive a power signal from the first source/drain region based on the power gating signal.

According to another aspect of the disclosure, there is provided an integrated circuit which may include: a backside wiring layer on a backside of a substrate, the backside wiring layer including a first backside pattern and a second backside pattern each extending in a first direction and isolated from each other in a second direction intersecting with the first direction; a contact on a front side of the substrate, the contact extending in the second direction; and a power gating switch on the front side of the substrate, the power gating switch connected to the first and second backside patterns. The power gating switch may include: a first source/drain region configured to receive a first supply voltage from the first backside pattern through the contact; a gate line structure configured to receive a power gating signal; and a second source/drain region connected to the second backside pattern, and configured to receive a power signal from the first source/drain region based on the power gating signal.

According to another aspect of the disclosure, there is provided an integrated circuit which may include: a backside wiring layer on a backside of a substrate, the backside wiring layer including a first backside pattern and a second backside pattern isolated from each other; a power gating switch on a front side of the substrate; a first backside via layer connected to the power gating switch and including a first backside via and a second backside via; and a second backside via layer between the backside wiring layer and the first backside via layer, the second backside via layer including a third backside via on the first backside pattern and a fourth backside via on the second backside pattern. The first backside via may be on the third backside via, and the second backside via may be on the fourth backside via. The power gating switch may include: a first source/drain region configured to receive a first supply voltage from the first backside pattern through the third backside via and the first backside via; a gate line structure configured to receive a power gating signal; and a second source/drain region connected to the second backside pattern through the fourth backside via and the second backside via, and configured to receive a power signal from the first source/drain region based on the power gating signal.

### BRIEF DESCRIPTION OF DRAWINGS

Embodiments will be more clearly understood from the following detailed description taken in conjunction with the accompanying drawings in which:
FIG. 1 shows a layout of an integrated circuit, according to one or more embodiments;
FIG. 2 is a circuit diagram of a power gating switch, according to one or more embodiments;
FIG. 3A is a cross-sectional view taken along line X1-X1' of FIG. 1, according to one or more embodiments, and FIG. 3B is a cross-sectional view taken along line X2-X2' of FIG. 1, according to one or more embodiments;
FIG. 4 shows a layout of an integrated circuit, according to one or more embodiments;
FIG. 5 is a circuit diagram of a power gating switch, according to one or more embodiments;
FIG. 6A is a cross-sectional view taken along line X3-X3' of FIG. 4, according to one or more embodiments, and FIG. 6B is a cross-sectional view taken along line X4-X4' of FIG. 4, according to one or more embodiments;
FIG. 7 shows a layout of an integrated circuit, according to one or more embodiments;
FIG. 8A is a cross-sectional view taken along line X5-X5' of FIG. 7, according to one or more embodiments, and FIG. 8B is a cross-sectional view taken along line X6-X6' of FIG. 7, according to one or more embodiments.
FIG. 9 shows a layout of an integrated circuit, according to one or more embodiments;
FIG. 10A is a cross-sectional view taken along line X7-X7' of FIG. 9, according to one or more embodiments, and FIG. 10B is a cross-sectional view taken along line X8-X8' of FIG. 9, according to one or more embodiments;
FIG. 11 shows a layout of an integrated circuit, according to one or more embodiments;
FIG. 12 shows an integrated circuit, according to one or more embodiments;
FIG. 13 shows an integrated circuit, according to one or more embodiments;
FIG. 14 shows a layout of an integrated circuit, according to one or more embodiments;
FIG. 15 is a perspective view of the integrated circuit of FIG. 14, according to one or more embodiments;
FIG. 16 shows a layout of an integrated circuit, according to one or more embodiments;
FIG. 17 is a perspective view of the integrated circuit of FIG. 16, according to one or more embodiments;
FIG. 18 shows a layout of an integrated circuit, according to one or more embodiments;
FIG. 19 is a circuit diagram of a power gating switch, according to one or more embodiments;
FIG. 20A is a cross-sectional view taken along line X9-X9' of FIG. 18, according to one or more embodiments, and FIG. 20B is a cross-sectional view taken along line X10-X10' of FIG. 18, according to one or more embodiments;
FIG. 21 shows a layout of an integrated circuit, according to one or more embodiments;
FIG. 22A is a cross-sectional view taken along line X11-X11' of FIG. 21, according to one or more embodiments, and FIG. 22B is a cross-sectional view taken along line X12-X12' of FIG. 21, according to one or more embodiments;
FIG. 23 shows a layout of an integrated circuit, according to one or more embodiments;
FIG. 24 is a circuit diagram of a power gating switch, according to one or more embodiments;
FIG. 25A is a cross-sectional view taken along line X13-X13' of FIG. 23, according to one or more embodiments, and FIG. 25B is a cross-sectional view taken along line X14-X14' of FIG. 23, according to one or more embodiments;
FIG. 26 shows a layout of an integrated circuit, according to one or more embodiments;
FIG. 27 is a circuit diagram of a power gating switch, according to one or more embodiments;
FIG. 28A is a cross-sectional view taken along line X15-X15' of FIG. 26, according to one or more embodiments, and FIG. 28B is a cross-sectional view taken along line X16-X16' of FIG. 26, according to one or more embodiments;
FIGS. 29A through 29D are diagrams showing devices, according to some embodiments;
FIG. 30 is a flowchart of a method of manufacturing an integrated circuit, according to one or more embodiments;
FIG. 31 is a block diagram of a system on chip, according to one or more embodiments; and
FIG. 32 is a block diagram of a computing system including a memory that stores a program, according to one or more embodiments.

### DETAILED DESCRIPTION OF EMBODIMENTS

Hereinafter, the disclosure will be described more fully with reference to the accompanying drawings, in which example embodiments of the disclosure are shown. In the accompanying drawings, like reference numerals may refer to like elements, and repeated descriptions of the like elements will be omitted. It will be understood that when an element or layer is referred to as being "over," "above," "on," "below," "under," "beneath," "connected to" or "coupled to" another element or layer, it can be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

Herein, an X-axis direction may be referred to as a first horizontal direction or a first direction, a Y-axis direction may be referred to as a second horizontal direction or a second direction, and a Z-axis direction may be referred to as a vertical direction. A plane made up of an X-axis and a Y-axis may be referred to as a horizontal plane.

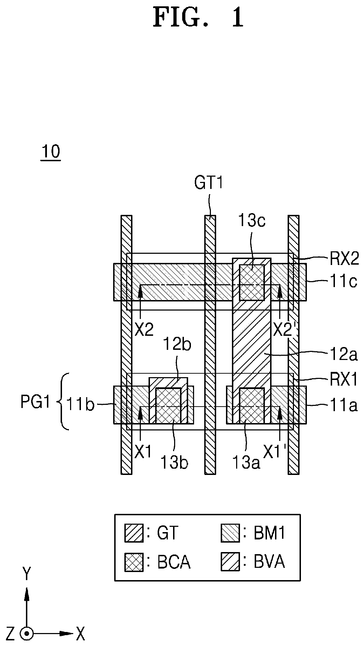

FIG. 1 shows a layout of an integrated circuit 10 according to one or more embodiments.

Referring to FIG. 1, the integrated circuit 10 may include active regions RX1 and RX2, gate line structures GT, backside contacts BCA, first backside vias BVA, and a first backside wiring layer BM1. The active regions RX1 and RX2 may each extend in a first direction X and may be spaced apart from each other in a second direction Y. The gate line structures GT may each extend in the second direction Y and may be spaced apart from each other in the first direction X. The active regions RX1 and RX2 and the gate line structures GT may constitute transistors.

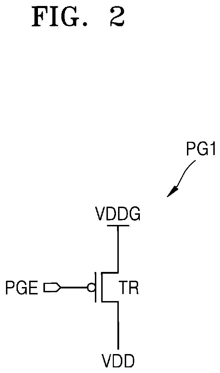

The integrated circuit 10 may include a power gating switch PG1 implemented with the active region RX1 and a gate line structure GT1, and the power gating switch PG1 may correspond to a power gating switch PG1 of FIG. 2. According to one or more embodiments, the power gating switch PG1 may be referred to as a power gating circuit or a power switch. According to one or more embodiments, a supply voltage may be provided to the power gating switch PG1 using the first backside wiring layer BM1, thereby improving a power performance area (PPA) of the integrated circuit 10.

The first backside wiring layer BM1 may include first, second, and third backside patterns 11a, 11b, and 11c each extending in the first direction X. The first and second backside patterns 11a and 11b may be spaced apart from each other in the first direction X, and the third backside pattern 11c may be spaced apart from the first and second backside patterns 11a and 11b in the second direction Y. For example, the first and second backside patterns 11a and 11b may be generated by applying a cutting layer to backside wiring extending in the first direction (X). In this way, by applying different voltages to patterns disposed on the same track of the same layer such as the first backside wiring layer BM1, for example, the first and second backside patterns 11a and 11b, by using the cutting layer, the area of the integrated circuit 10 may be reduced. According to one or more embodiments, an extension direction of each of the first, second, and third backside patterns 11a, 11b, and 11c and an arrangement of the first, second, and third backside patterns 11a, 11b, and 11c may vary.

The first backside vias BVA may be disposed on the first backside wiring layer BM1 and may be electrically connected to the first backside wiring layer BM1. The first backside vias BVA may include a backside via 12a electrically connected to the first and third backside patterns 11a and 11c, and a backside via 12b electrically connected to the second backside pattern 11b. The backside via 12a may extend in the second direction Y. According to one or more embodiments, an extension direction of each of the backside vias 12a and 12b and an arrangement of the backside vias 12a and 12b may vary.

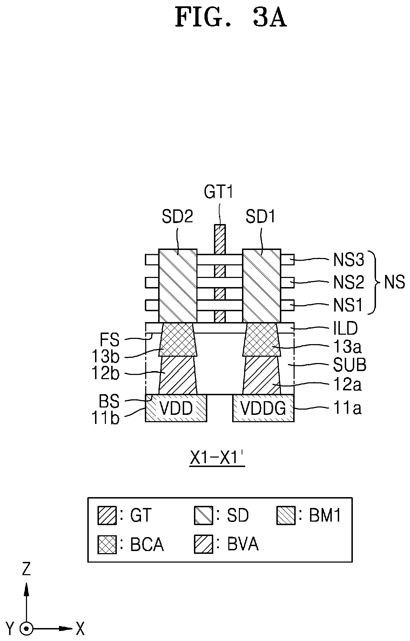

The backside contacts BCA may be disposed on the first backside vias BVA and may be electrically connected to the first backside vias BVA. The backside contacts BCA may include a backside contact 13a electrically connected to the first via 12a and a backside contact 13b electrically connected to the backside via 12b. A source/drain region of the active region RX2 may be electrically connected to the third backside pattern 11c through the backside contact 13c and the backside via 12a. A source/drain region (e.g., SD1 in FIG. 3A) of the active region RX1 may be electrically connected to the first backside pattern 11a through the backside contact 13a and the backside via 12a, and a source/drain region (e.g., SD2 in FIG. 3A) of the active region RX1 may be electrically connected to the second backside pattern 11b through the backside contact 13b and the backside via 12b.

FIG. 2 is a circuit diagram of the power gating switch PG1 according to one or more embodiments.

Referring to FIGS. 1 and 2 together, the power gating switch PG1 may include a transistor TR including a source receiving a first supply voltage, a gate receiving a power gating signal PGE, and a drain providing a second supply voltage. For example, the first supply voltage may correspond to a global power supply voltage VDDG or an external power supply voltage VDDPE, and the second supply voltage may correspond to a virtual power supply voltage VDD or an internal power supply voltage VDDP. The power gating switch PG1 may selectively connect a global power line (e.g., the backside pattern 11a) to which the global power voltage VDDG is applied, to a virtual power line (e.g., the backside pattern 11b) to which the virtual power supply voltage VDD is provided. Accordingly, a driving voltage, that is, the virtual power supply voltage VDD, provided to a logic transistor included in the integrated circuit 10 may be adjusted, and thus a power mode of the integrated circuit 10 may be adjusted.

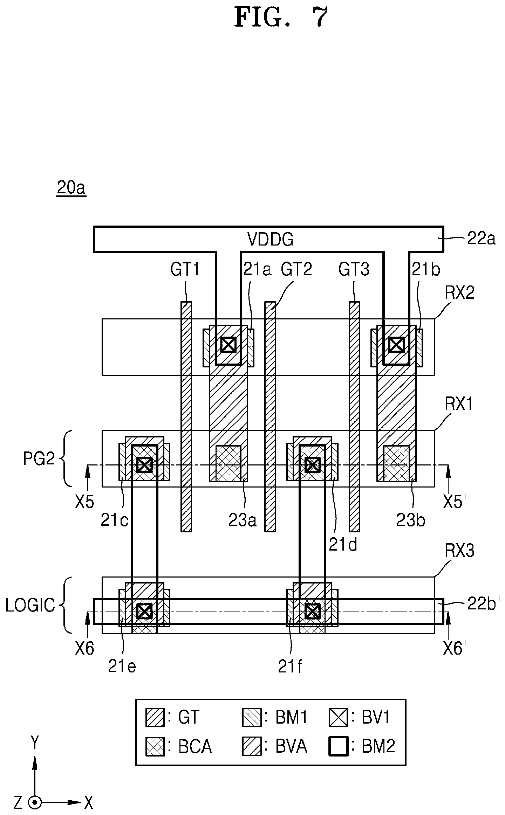

In a power-on mode, when the power gating signal PGE is at an enable level, for example, a logic low level, the transistor TR may be turned on and the global power supply voltage VDDG applied to a source may be delivered as a power signal, for example, to the drain of the transistor TR so that the drain of the transistor TR can provide the virtual power supply voltage VDD to another circuit element based on the power signal from the source. For example, the power gating switch PG1 may provide the virtual power supply voltage VDD to a logic transistor (e.g., LOGIC in FIG. 7) included in the integrated circuit 10, and thus the logic transistor of the integrated circuit 10 may operate normally. Here, the virtual power supply voltage VDD may not be equal to the global power supply voltage VDDG. For example, the virtual power supply voltage VDD may be smaller than the global power supply voltage VDDG because of an IR drop at a channel structure connecting the source region and the drain region.

In a power-off mode, when the power gating signal PGE is at a disable level, for example, a logic high level, the transistor TR may be turned off and the global power supply voltage VDDG applied to the source of the transistor TR may not be delivered to the drain of the transistor TR. Accordingly, the power gating switch PG1 may not provide the virtual power supply voltage VDD to the logic transistor, and thus power consumption of the integrated circuit 10 may be reduced.

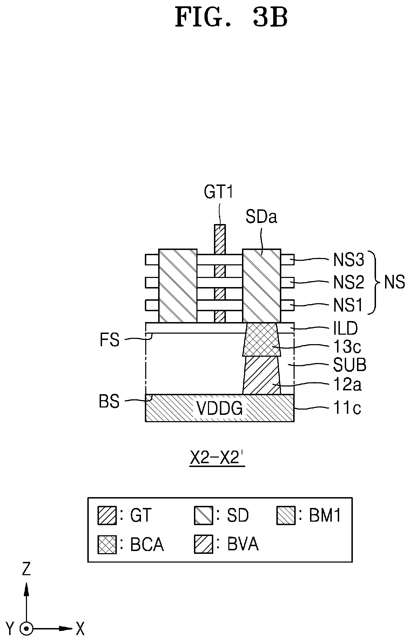

FIG. 3A is a cross-sectional view taken along line X1-X1' of FIG. 1 according to one or more embodiments, and FIG. 3B is a cross-sectional view taken along line X2-X2' of FIG. 1 according to one or more embodiments.

Referring to FIGS. 1 through 3B together, the integrated circuit 10 may be implemented as a semiconductor device, and a substrate SUB on which the semiconductor device is formed may have a first surface or first side FS and a second surface or second side BS. For example, the first side FS may be a side on which circuit devices such as transistors are disposed, and the first side FS may be referred to as a "front side FS." The second side BS may be a side opposite to the first side FS and the second side BS may be referred to as a "back side BS."

The integrated circuit 10 may implement a power distribution network (PDN) using frontside wiring layers and backside wiring layers. Accordingly, some of signals and/or power applied to the integrated circuit 10 may be transferred through the frontside wiring layers, i.e., a frontside PDN (FSPDN), and the others may be transferred through the backside wiring layers, i.e., a backside PDN (BSPDN). Therefore, compared to a structure in which wires are arranged only on the front side FS of the substrate SUB, routing complexity may be greatly reduced and the length of each wire or each via may also be reduced, leading to improvement in the performance of the integrated circuit 10.

The substrate SUB may include any one of silicon, silicon-on-insulator, silicon-on-sapphire, germanium, silicon-germanium, and gallium-arsenide. A bottom dielectric (or diffusion) isolation (BDI) layer may be disposed above the substrate SUB. The BDI layer may include an insulating material. The insulating material may include any one of an oxide layer, a nitride layer, and an oxynitride layer.

According to some embodiments, the substrate SUB may correspond to a bulkless substrate. In a process of manufacturing the integrated circuit 10, gate line structures, source/drain regions, contacts, vias, and/or wiring layers may be formed on a front surface of the substrate SUB, thereby forming a device wafer. Subsequently, the device wafer may be temporarily bonded to a carrier wafer, and a back-grinding process may be performed on the device wafer, thereby removing at least a portion of the substrate SUB. As such, a wafer obtained by back-grinding a substrate such that the height of the substrate is equal to or less than a reference height may be referred to as a "bulkless wafer" or a "bulkless substrate".

The active regions RX1 and RX2 may be limited by a device isolation layer such as shallow trench isolation (STI) and may be referred to as a diffusion region. The diffusion region is a region doped with impurities that change the electrical characteristics of a substrate material and may form source/drain regions SD of a transistor. The source/drain regions SD may include an epitaxial region of a semiconductor material such as silicon, boron, phosphorus, germanium, carbon, SiGe, and/or SiC.

A nanosheet stack NS extending in the first direction X may be disposed on the front side FS of the substrate SUB. The nanosheet stack NS may include a plurality of nanosheets overlapping in the vertical direction Z, for example, first through third nanosheets NS1 through NS3. For example, the nanosheet stack NS may be doped with N-type impurities and may form an N-type transistor. As another example, the nanosheet stack NS may be doped with P-type impurities and may form a P-type transistor. The nanosheet stack NS may include Si, Ge, or SiGe. According to one or more other embodiments, the nanosheet stack NS may include InGaAs, InAs, GaSb, InSb, or a combination thereof.

The gate line structures GT may each extend in the second direction Y and may be spaced apart from each other in the first direction X. Each of the gate line structures GT may surround the first through third nanosheets NS1 through NS3 while surrounding the nanosheet stack NS. Accordingly, the first through third nanosheets NS1 through NS3 may have a gate-all-around (GAA) structure. The gate line structures GT may be defined as conductive segments including a conductive material such as polysilicon or one or more metals. A gate insulating layer may be interposed between each of the gate line structures GT and the first through third nanosheets NS1 through NS3.

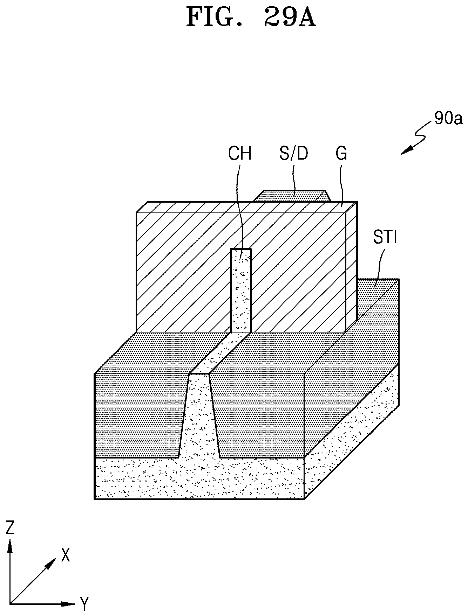

As such, the integrated circuit 10 may include the nanosheet stack NS, but the disclosure is not limited thereto. According to some embodiments, the integrated circuit 10 may include a fin structure instead of the nanosheet stack NS, and accordingly, transistors included in the integrated circuit 10 may be implemented as fin field-effect transistors (FinFETs). A power gating switch according to embodiments will now be illustrated as a multi-bridge channel field-effect transistor (MBCFET) including the nanosheet stack NS. However, this is only one or more embodiments, and the power gating switch according to embodiments may be implemented in various ways, as described in more detail with reference to FIGS. 29A through 29D.

The first backside pattern 11a may be electrically connected to the source/drain region SD1 through the backside via 12a and the backside contact 13a. The source/drain region SD1 may correspond to a source region of the power gating switch PG1. The second backside pattern 11b may be electrically connected to the source/drain region SD2 through the backside via 12b and the backside contact 13b. The source/drain region SD2 may correspond to a drain region of the power gating switch PG1. The third backside pattern 11c may be electrically connected to a source/drain region SDa through the backside via 12a and the backside contact 13c.

As such, the backside vias 12a and 12b and the backside contacts 13a through 13c may connect layers and elements on the back side BS to elements on the front side FS, e.g., the source/drain regions SD1-SD3. A structure connecting a contact to a bottom surface of each of the source/drain regions SD1-SD3 may be referred to as a "direct backside contact (DBC)". According to one or more embodiments, the DBC may include a backside contact and/or a backside via. However, the disclosure is not limited thereto, and the backside contact and the backside via connected thereto may be formed as a single contact structure in a form of via, according to one or more other embodiments.

The gate line structure GT1 and the source/drain regions SD1 and SD2 may form the power gating switch PG1. The gate line structure GT1 may be driven according to the power gating signal PGE. The first backside pattern 11a may receive a first supply voltage, for example, always-on power or the global power supply voltage VDDG, and thus may be referred to as a global power line. The second backside pattern 11b may receive a second supply voltage, for example, a power supply voltage or the virtual power supply voltage VDD, and thus may be referred to as a virtual power line.

The source/drain region SD1, for example, the source region, may be electrically connected to the first backside pattern 11a through the backside contact 13a and the backside via 12a, and may receive the global supply voltage VDDG from the first backside pattern 11a. The source/drain region SD2, for example, the drain region, may transfer the second supply voltage, e.g., the virtual power supply voltage VDD, to the second backside pattern 11b through the backside contact 13b and the backside via 12b. The integrated circuit 10 may selectively connect the first backside pattern 11a to the second backside surface pattern 11b in response to a control signal, e.g., the power gating signal PGE of FIG. 2, thereby selectively transferring the global power supply voltage VDDG applied to the first backside pattern 11a to the second backside pattern 11b. Accordingly, a driving voltage and a power mode of the elements included in the integrated circuit 10 may be adjusted, and thus the power consumption of the integrated circuit 10 may be improved.

As described above, the integrated circuit 10 may implement a PDN by using backside wiring layers including the first backside wiring layer BM1. Accordingly, power applied to the source/drain regions may be transferred through the backside wiring layers, and signals applied to the source/drain regions and/or the gate line structures may be transferred through a frontside wiring layer. Therefore, according to the present embodiment, compared to a structure in which wires are arranged only on a front side of a substrate, routing complexity may be greatly reduced, and the length of each wire or each via may also be reduced, leading to improvement in the performance of the integrated circuit 10. Further, the global power supply voltage VDDG applied to the source/drain region SDa on the active region RX2 may also be transmitted to the source/drain region SD1 on the active region RX1 which is already powered by the global power supply voltage VDDG, through the backside via 12a. Thus, the virtual power supply voltage VDD provided from the source/drain region SD2, which is connected to the source/drain regions SD1, may have further improved power performance.

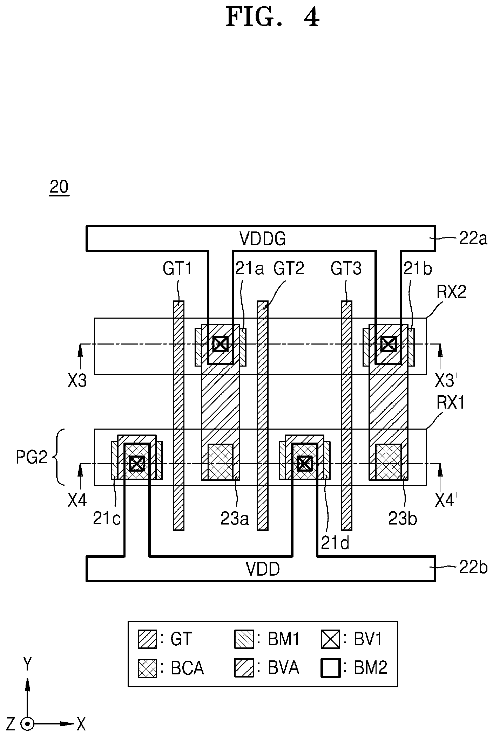

FIG. 4 shows a layout of an integrated circuit 20 according to one or more embodiments.

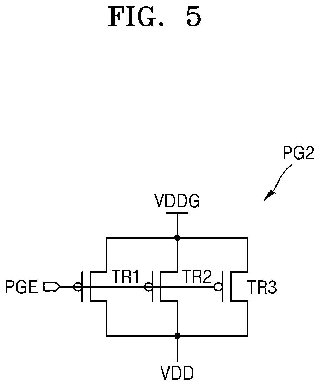

Referring to FIG. 4, the integrated circuit 20 may correspond to a modification of the integrated circuit 10 of FIG. 1, and may further include second backside vias BV1 and second backside wiring layers BM2, compared to the integrated circuit 10 of FIG. 1. According to one or more embodiments, the integrated circuit 20 may include a power gating circuit or power gating switch PG2 implemented with an active region RX1 and gate line structures GT1, GT2, and GT3, and the power gating switch PG2 may correspond to the power gating switch PG1 of FIG. 5.

The first backside wiring layer BM1 may include backside patterns 21a through 21d. The second backside wiring layer BM2 may include backside wiring lines 22a and 22b insulated from each other. Each of the backside wiring lines 22a and 22b may be implemented as a polygon including bidirectional patterns including a pattern extending in the first direction X and a pattern extending in the second direction Y. The backside wiring line 22a may receive the first supply voltage, for example, the global power supply voltage VDDG, and the backside wiring line 22b may receive the second supply voltage, for example, the virtual power supply voltage VDD. The second backside vias BV1 may be disposed between the second backside wiring layer BM2 and the first backside wiring layer BM1, respectively. The first backside vias BVA may be disposed between the first backside wiring layer BM1 and the backside contacts BCA, respectively. The first backside vias BVA may include backside vias 23a and 23b each extending in the second direction Y.

FIG. 5 is a circuit diagram of the power gating switch PG2 according to one or more embodiments.

Referring to FIGS. 4 and 5 together, the power gating switch PG2 may include first, second, and third transistors TR1, TR2, and TR3 connected in parallel with each other. Each of the first, second, and third transistors TR1, TR2, and TR3 may include a source receiving a first supply voltage, a gate receiving a power gating signal PGE, and a drain providing a second supply voltage. For example, the first supply voltage may correspond to a global power supply voltage VDDG or an external power supply voltage VDDPE, and the second supply voltage may correspond to a virtual power supply voltage VDD or an internal power supply voltage VDDP. The power gating switch PG2 may selectively connect a global power line (e.g., the backside wiring line 22a) to which the global power voltage VDDG is applied, to a virtual power line (e.g., the backside wiring line 22b) to which the virtual power voltage VDD is provided. Accordingly, a driving voltage, that is, the virtual power supply voltage VDD, provided to a logic transistor included in the integrated circuit 20 may be adjusted, and thus a power mode of the integrated circuit 20 may be adjusted.

In a power-on mode, when the power gating signal PGE is at an enable level, for example, a logic low level, the first, second, and third transistors TR1, TR2 and TR3 may be turned on and the global power supply voltage VDDG applied to sources of the first, second, and third transistors TR1, TR2 and TR3 may be transferred as a power signal, for example, the virtual power supply voltage VDD to drains of the first, second, and third transistors TR1, TR2 and TR3 so that the drains of the first, second and third transistors TR1, TR2 and TR3 can provide the virtual power supply voltage VDD to another circuit element. For example, the power gating switch PG2 may provide the virtual power supply voltage VDD to a logic transistor (e.g., LOGIC in FIG. 7) included in the integrated circuit 20, and thus the logic transistor of the integrated circuit 20 may operate normally.

In a power-off mode, when the power gating signal PGE is at a disable level, for example, a logic high level, the first, second, and third transistors TR1, TR2 and TR3 may be turned off and the global power supply voltage VDDG applied to the sources of the first, second, and third transistors TR1, TR2 and TR3 may not be transferred to the drains of the first, second, and third transistors TR1, TR2 and TR3. Accordingly, the power gating switch PG2 may not provide the virtual power supply voltage VDD to the logic transistor, and thus power consumption of the integrated circuit 20 may be reduced.

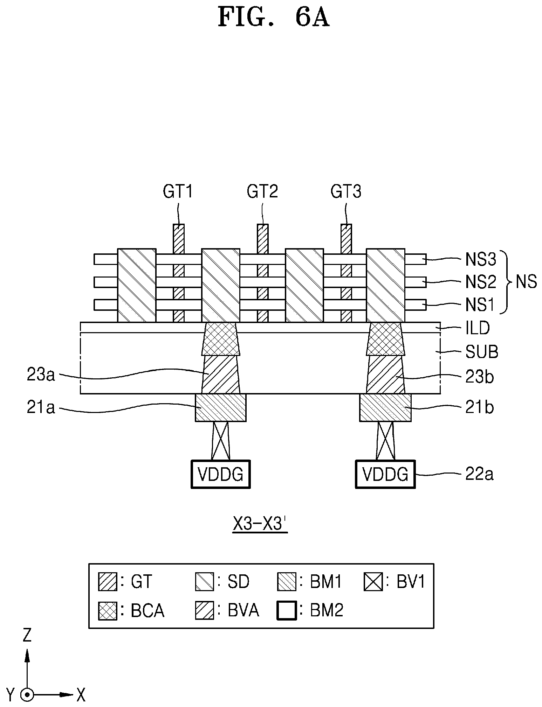

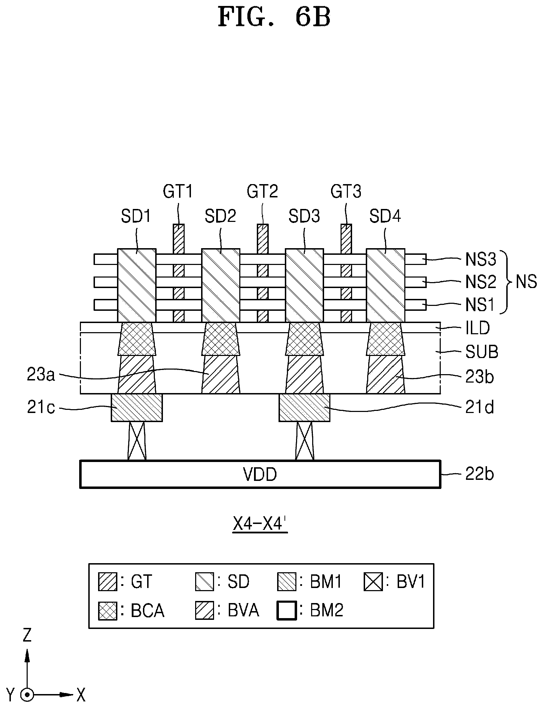

The active region RX1 and the gate line structure GT1 may form the first transistor TR1, the active region RX1 and the gate line structure GT2 may form the second transistor TR2, and the active region RX1 and the gate line structure GT3 may form the third transistor TR3. The integrated circuit 20 is described below in more detail with reference to FIGS. 6A and 6B.

FIG. 6A is a cross-sectional view taken along line X3-X3' of FIG. 4 according to one or more embodiments, and FIG. 6B is a cross-sectional view taken along line X4-X4' of FIG. 4 according to one or more embodiments.

Referring to FIGS. 4 through 6B together, the backside wiring line 22a may receive the first supply voltage, for example, the global power supply voltage VDDG. The backside patterns 21a and 21b may receive the first supply voltage from the backside wiring line 22a through the second backside vias BV1, respectively. The first backside vias 23a and 23b may be disposed on the backside patterns 21a and 21b, respectively, and may each extend in the second direction Y. Accordingly, the first backside vias 23a and 23b may receive the first supply voltage from the backside wiring line 22a through the backside patterns 21a and 21b and the second backside vias BV1, respectively.

The source/drain regions SD may include first, second, third, and fourth source/drain regions SD1, SD2, SD3, and SD4. The gate line structure GT1 and the first and second source/drain regions SD1 and SD2 may form the first transistor TR1, the gate line structure GT2 and the second and third source/drain regions SD2 and SD3 may form the second transistor TR2, and the gate line structure GT3 and the third and fourth source/drain regions SD3 and SD4 may form the third transistor TR3.

In the first transistor TR1, the first source/drain region SD1 may correspond to a drain region and the second source/drain region SD2 may correspond to a source region. The second source/drain region SD2 may be electrically connected to the first backside via 23a through the backside contact BCA. The second source/drain region SD2 may receive the first supply voltage from the backside wiring line 22a through the second backside via BV1, the backside pattern 21a, the first backside via 23a, and the backside contact BCA. When the power gating signal PGE is at an enable level, the first transistor TR1 may be turned on and the first source/drain region SD1 may transfer the virtual power voltage VDD to the backside wiring line 22b through the backside contact BCA, the first backside via BVA, the backside pattern 21c, and the second backside via BV1.

In the second transistor TR2, the second source/drain region SD2 may correspond to a source region and the third source/drain region SD3 may correspond to a drain region. The second source/drain region SD2 may be electrically connected to the first backside via 23a through the backside contact BCA. The second source/drain region SD2 may receive the first supply voltage from the backside wiring line 22a through the second backside via BV1, the backside pattern 21a, the first backside via, and the backside contact BCA. When the power gating signal PGE is at an enable level, the second transistor TR2 may be turned on and the third source/drain region SD3 may transfer the virtual power voltage VDD to the backside wiring line 22b through the backside contact BCA, the first backside via BVA, the backside pattern 21d, and the second backside via BV1.

In the third transistor TR3, the third source/drain region SD3 may correspond to a drain region and the fourth source/drain region SD4 may correspond to a source region. The fourth source/drain region SD4 may be electrically connected to the first backside via 23b through the backside contact BCA. The fourth source/drain region SD4 may receive the first supply voltage from the backside wiring line 22a through the second backside via BV1, the backside pattern 21b, the first backside via 23b, and the backside contact BCA. When the power gating signal PGE is at an enable level, the third transistor TR3 may be turned on and the third source/drain region SD3 may transfer the virtual power voltage VDD to the backside wiring line 22b through the backside contact BCA, the first backside via BVA, the backside pattern 21d, and the second backside via BV1.

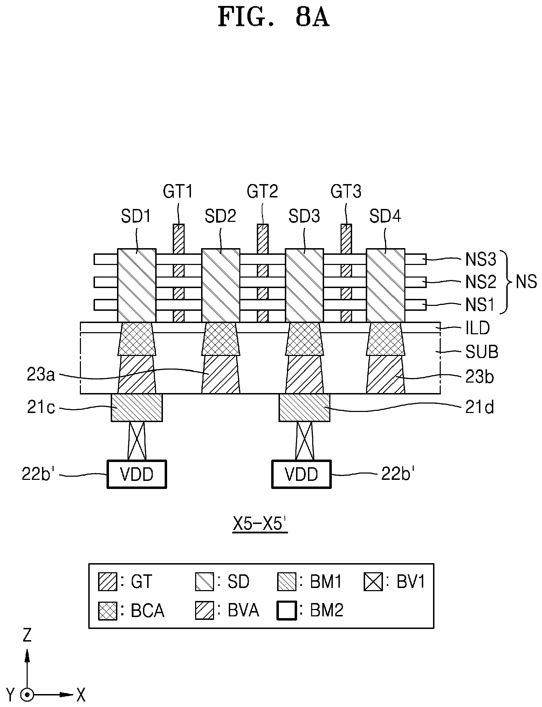

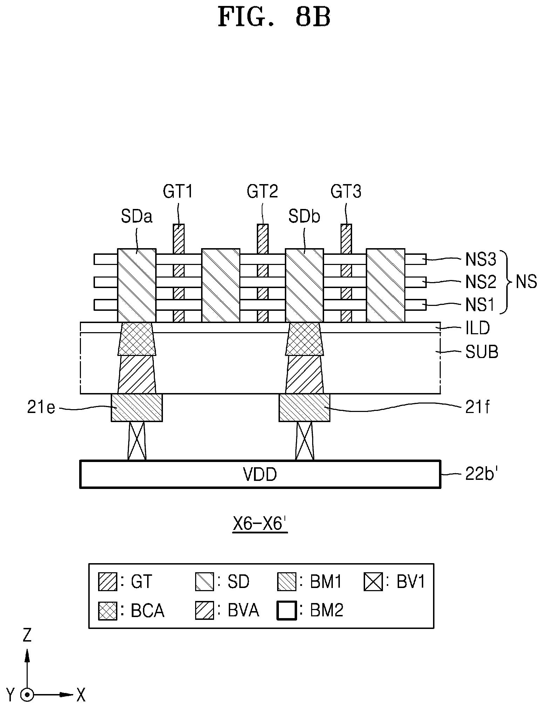

FIG. 7 shows a layout of an integrated circuit 20a according to one or more embodiments. FIG. 8A is a cross-sectional view taken along line X5-X5' of FIG. 7 according to one or more embodiments, and FIG. 8B is a cross-sectional view taken along line X6-X6' of FIG. 7 according to one or more embodiments.

Referring to FIGS. 7 through 8B, the integrated circuit 20a may correspond to a modification of the integrated circuit 20 of FIG. 4, and may further include a logic transistor LOGIC implemented in an active region RX3, compared to the integrated circuit 20 of FIG. 4. For example, the logic transistor LOGIC may include a P-type transistor, but the disclosure is not limited thereto. The first backside wiring layer BM1 may include backside patterns 21a through 21f. The second backside wiring layer BM2 may include backside wiring lines 22a and 22b' insulated from each other. Each of the backside wiring lines 22a and 22b' may be implemented as a polygon including bidirectional patterns including a pattern extending in the first direction X and a pattern extending in the second direction Y. For example, the backside wiring line 22a may receive the first supply voltage, for example, the global power supply voltage VDDG, and the backside wiring line 22b' may receive the second supply voltage, for example, the virtual power supply voltage VDD.

When the power gating signal PGE is at an enable level, the first, second, and third transistors TR1, TR2, and TR3 may be turned on and the virtual power supply voltage VDD may be supplied to the backside patterns 21c and 21d. The backside patterns 21c and 21d may be electrically connected to the backside wiring line 22b' through the second backside vias BV1, and accordingly, the backside wiring line 22b' may receive the virtual power supply voltage VDD. In the logic transistor LOGIC, a source/drain region SDa may be electrically connected to the backside wiring line 22b' through the backside contact BCA, the first backside via BVA, the backside pattern 21e, and the second backside via BV1, and a source/drain region SDb may be electrically connected to the backside wiring line 22b' through the backside contact BCA, the first backside via BVA, the backside pattern 21f, and the second backside via BV1. Accordingly, the source/drain regions SDa and SDb may receive the virtual power voltage VDD from the backside wiring line 22b', and the P-type transistors included in the logic transistor LOGIC may operate normally.

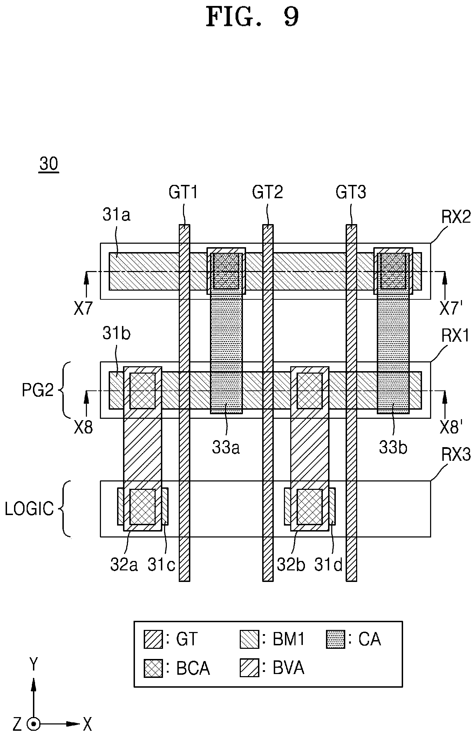

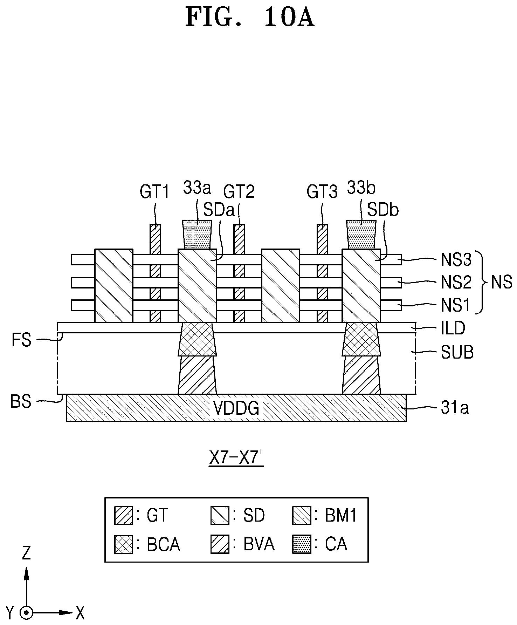

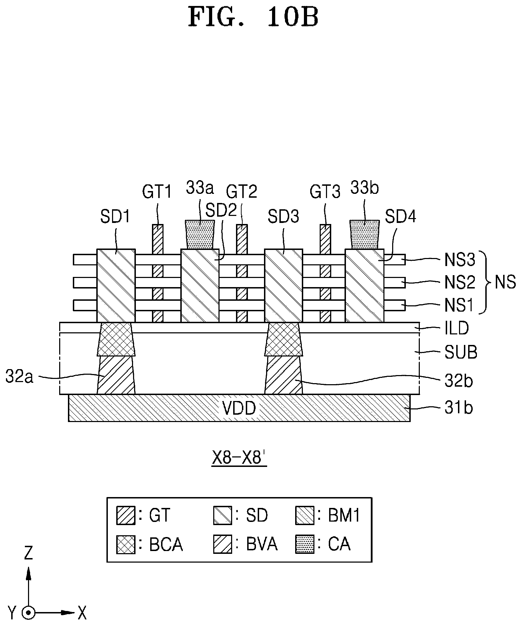

FIG. 9 shows a layout of an integrated circuit 30 according to one or more embodiments. FIG. 10A is a cross-sectional view taken along line X7-X7' of FIG. 9 according to one or more embodiments, and FIG. 10B is a cross-sectional view taken along line X8-X8' of FIG. 9 according to one or more embodiments.

Referring to FIGS. 9 through 10B together, the integrated circuit 30 may include active regions RX1 through RX3, gate line structures GT, contacts CA, backside contacts BCA, first backside vias BVA, and a first backside wiring layer BM1. The active regions RX1 through RX3 may each extend in a first direction X and may be spaced apart from each other in a second direction Y. The gate line structures GT may each extend in the second direction Y and may be spaced apart from each other in the first direction X. The active regions RX1 through RX3 and the gate line structures GT may constitute transistors. The integrated circuit 30 may include a power gating circuit or power gating switch PG2 implemented with an active region RX1 and gate line structures GT1, GT2, and GT3, and the power gating switch PG2 may correspond to the power gating switch PG2 of FIG. 5.

The contacts CA may be disposed in the front side FS of the substrate SUB and may include contacts 33a and 33b each extending in the second direction Y. The first backside wiring layer BM1 may include backside patterns 31a through 31d. The backside patterns 31a and 31b may each extend in the first direction X and may be spaced apart from each other in the second direction Y. The first backside vias BVA may be disposed on the first backside wiring layer BM1 and may be electrically connected to the first backside wiring layer BM1. The first backside vias BVA may include a backside via 32a electrically connected to the backside patterns 31b and 31c, and a backside via 32b electrically connected to the backside patterns 31b and 31d. The backside vias 32a and 32b may each extend in the second direction Y. The backside contacts BCA may be disposed on the first backside vias BVA and may be electrically connected to the first backside vias BVA. According to one or more embodiments, an extension direction of each of the backside patterns 31a through 31d, the backside vias 32a and 32b, and the backside contacts BCA and an arrangement of the backside patterns 31a through 31d, the backside vias 32a and 32b, and the backside contacts BCA may vary.

The backside pattern 31a may receive the first supply voltage, for example, the global power supply voltage VDDG. The backside pattern 31a may be electrically connected to source/drain regions SDa and SDb of the active region RX2 through the first backside vias BVA and the backside contacts BCA, respectively. The contacts 33a and 33b may be disposed on the source/drain regions SDa and SDb, respectively. The source/drain regions SD2 and SD4 of the active region RX1 may be electrically connected to the source/drain regions SDa and SDb of the active region RX2, respectively, through the contacts 33a and 33b. Accordingly, the source/drain regions SD2 and SD4 may receive the first supply voltage from the backside pattern 31a through the contacts 33a and 33b, the source/drain regions SDa and SDb, the backside contacts BCA, and the backside vias BVA.

The gate line structures GT1 through GT3 and the source/drain regions SD1 through SD4 may form the power gating switch PG2, and the gate line structures GT1 through GT3 may be driven according to the power gating signal PGE. The source/drain regions SD1 and SD3 may transfer the second supply voltage, e.g., the virtual power supply voltage VDD, to the backside pattern 31b through the backside contacts BCA and the backside vias 32a and 32b, respectively. Additionally, the logic transistor LOGIC may receive the virtual power supply voltage VDD through the backside vias 32a and 32b.

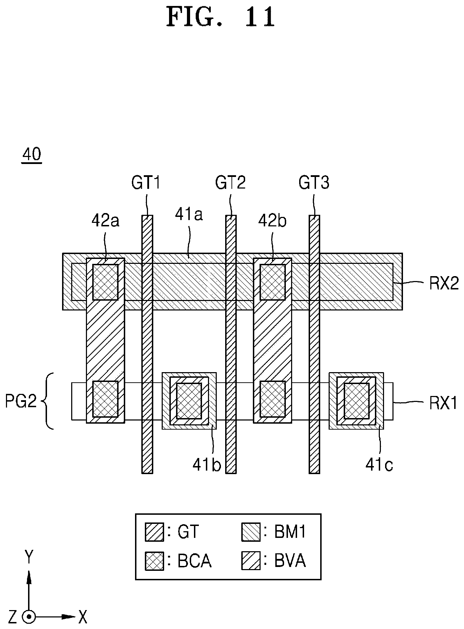

FIG. 11 shows a layout of an integrated circuit 40 according to one or more embodiments.

Referring to FIG. 11, the integrated circuit 40 may include active regions RX1 and RX2, gate line structures GT, backside contacts BCA, first backside vias BVA, and a first backside wiring layer BM1. The integrated circuit 40 may include a power gating circuit or power gating switch PG2 implemented with the active region RX1 and gate line structures GT1, GT2, and GT3, and the power gating switch PG2 may correspond to the power gating switch PG2 of FIG. 5.

The first backside wiring layer BM1 may include backside patterns 41a through 41c. The backside pattern 41a may extend in the first direction X, and may be spaced apart from the backside patterns 41b and 41c in the second direction Y. The backside pattern 41a may be at least partially overlapped by the active region RX2. The backside patterns 41b and 41c may be at least partially overlapped by the active region RX1. The first backside vias BVA may be disposed on the first backside wiring layer BM1 and may be electrically connected to the first backside wiring layer BM1. The first backside vias BVA may include backside vias 42a and 42b each extending in the second direction Y on the backside pattern 41a. The backside contacts BCA may be disposed on the first backside vias BVA.

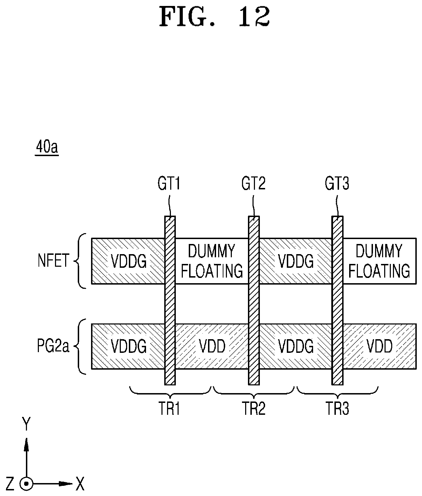

FIG. 12 shows an integrated circuit 40a according to one or more embodiments.

Referring to FIG. 12, the integrated circuit 40a may correspond to an implementation example of the integrated circuit 40 of FIG. 11. The integrated circuit 40a may include a power gating switch PG2a and an N-type transistor NFET. The power gating switch PG2a may include a first transistor TR1 including the gate line structure GT1, a second transistor TR2 including the gate line structure GT2, and a third transistor TR3 including the gate line structure GT3. A source region of each of the first through third transistors TR1 through TR3 may receive the global power supply voltage VDDG from an epitaxial region, that is, a source/drain region, of the N-type transistor NFET through a frontside wiring layer or a backside wiring layer. For example, the N-type transistor NFET may be a dummy transistor. For example, an input terminal of the N-type transistor NFET may be floated.

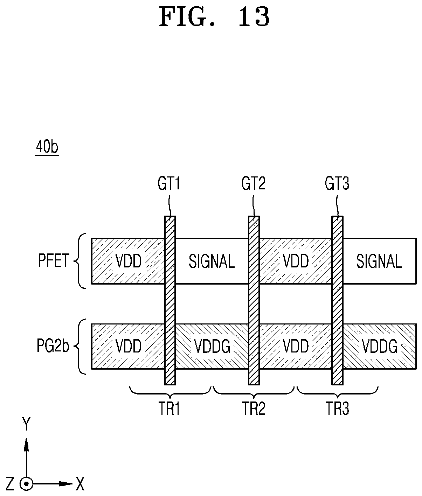

FIG. 13 shows an integrated circuit 40b according to one or more embodiments.

Referring to FIG. 13, the integrated circuit 40b may correspond to an implementation example of the integrated circuit 40 of FIG. 11. The integrated circuit 40b may include a power gating switch PG2b and a P-type transistor PFET. The power gating switch PG2b may include a first transistor TR1 including the gate line structure GT1, a second transistor TR2 including the gate line structure GT2, and a third transistor TR3 including the gate line structure GT3. A drain region of each of the first through third transistors TR1 through TR3 may transfer the virtual power supply voltage VDD to an epitaxial region, that is, a source/drain region, of the P-type transistor PFET through a frontside wiring layer or a backside wiring layer. For example, the P-type transistor PFET may be a real transistor and may constitute a logic transistor. Accordingly, one terminal of the P-type transistor PFET may provide a signal or an output signal.

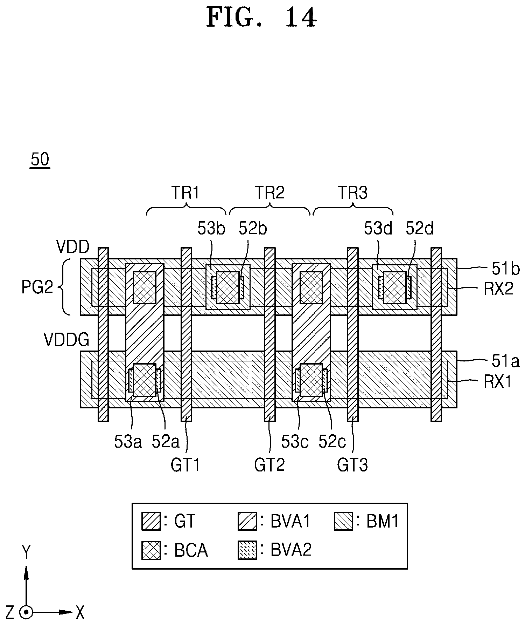

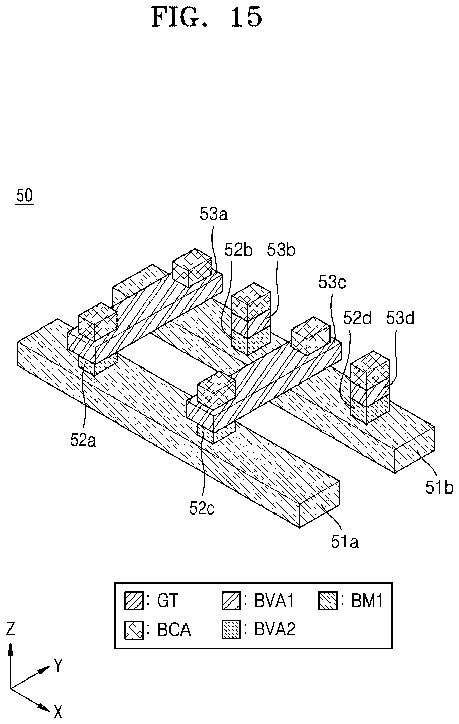

FIG. 14 shows a layout of an integrated circuit 50 according to one or more embodiments. FIG. 15 is a perspective view of the integrated circuit 50 of FIG. 14, according to one or more embodiments.

Referring to FIGS. 14 and 15 together, the integrated circuit 50 may include active regions RX1 and RX2, gate line structures GT, backside contacts BCA, a first backside via layer BVA1, a second backside via layer BVA2, and a first backside wiring layer BM1. In this case, the first and second backside via layers BVA1 and BVA2 may be disposed between the first backs wiring layer BM1 and the backside contacts BCA and may be stacked in a vertical direction Z. The second backside via layer BVA2 may be disposed on the first backside wiring layer BM1, the first backside via layer BVA1 may be disposed on the second back via layer BVA2, and the backside contacts BCA may be disposed on the first backside via layer BVA1. The integrated circuit 50 may include a power gating circuit or power gating switch PG2 implemented with an active region RX2 and gate line structures GT1, GT2, and GT3, and the power gating switch PG2 may correspond to the power gating switch PG2 of FIG. 5.

The first backside wiring layer BM1 may include backside patterns 51a and 51b each extending in the first direction X and spaced apart from each other in the second direction Y. The active region RX1 may overlap the backside pattern 51a, and the active region RX2 may be overlap the backside pattern 51b. The backside pattern 51a may receive the first supply voltage, for example, the global power supply voltage VDDG, and the backside pattern 51b may receive the second supply voltage, for example, the virtual power supply voltage VDD.

The second backside via layer BVA2 may include second backside vias 52a and 52c disposed on the backside pattern 51a, and second backside vias 52b and 52d disposed on the backside pattern 51b. The first backside via layer BVA1 may include first backside vias 53a through 53d respectively disposed on the second backside vias 52a through 52d. In this case, the first backside vias 53a and 53c may each extend in the second direction Y. As such, according to the present embodiment, two layers including a first layer, for example, the first backside via layer BVA1, and a second layer, for example, the second backside via layer BVA2, may be arranged between the first backside wiring layer BM1 and the backside contacts BCA, thereby implementing the power gating switch PG2 without forming a dummy transistor.

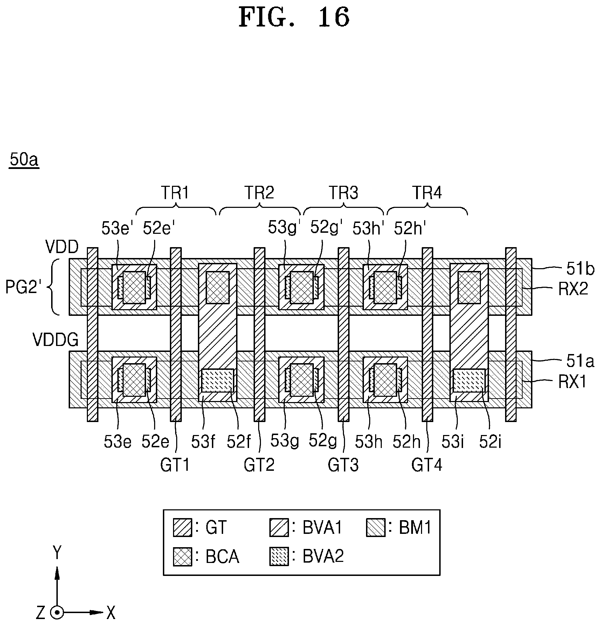

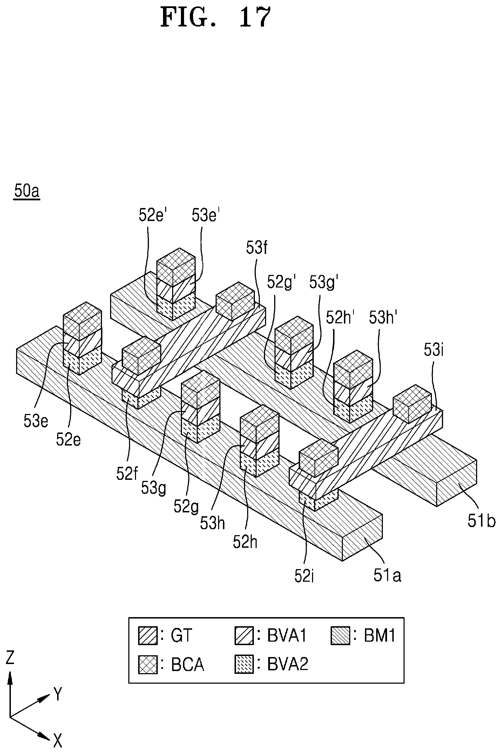

FIG. 16 shows a layout of an integrated circuit 50a according to one or more embodiments. FIG. 17 is a perspective view of the integrated circuit 50a of FIG. 16, according to one or more embodiments.

Referring to FIGS. 16 and 17 together, the integrated circuit 50a may include active regions RX1 and RX2, gate line structures GT, backside contacts BCA, a first backside via layer BVA1, a second backside via layer BVA2, and a first backside wiring layer BM1. The integrated circuit 50a may correspond to a modification of the integrated circuit 50 of FIG. 14. For example, the integrated circuit 50a may include a power gating switch circuit or power gating switch PG2' including first, second, third, and fourth transistors TR1, TR2, TR3, and TR4 connected in parallel with each other.

The second backside via layer BVA2 may include second backside vias 52e through 52i electrically connected to a backside pattern 51a and second backside vias 52e' through 52h' electrically connected to a backside pattern 51b. The first backside via layer BVA1 may include first backside vias 53e through 53i electrically connected to the second backside vias 52e through 52i and first backside vias 53e' through 53h' electrically connected to the second backside vias 52e' through 52h'.

Sources of the first and second transistors TR1 and TR2 may receive the first supply voltage from the backside pattern 51a through the first backside via 53f extending in the second direction Y and the backside contact BCA, and a source of the fourth transistor TR4 may receive the first supply voltage from the backside pattern 51a through the first backside via 53i extending in the second direction Y and the backside contact BCA. As such, according to the present embodiment, two layers including a first layer, for example, the first backside via layer BVA1, and a second layer, for example, the second backside via layer BVA2, may be arranged between the first backside wiring layer BM1 and the backside contacts BCA, thereby implementing the power gating switch PG2' without forming a dummy transistor.

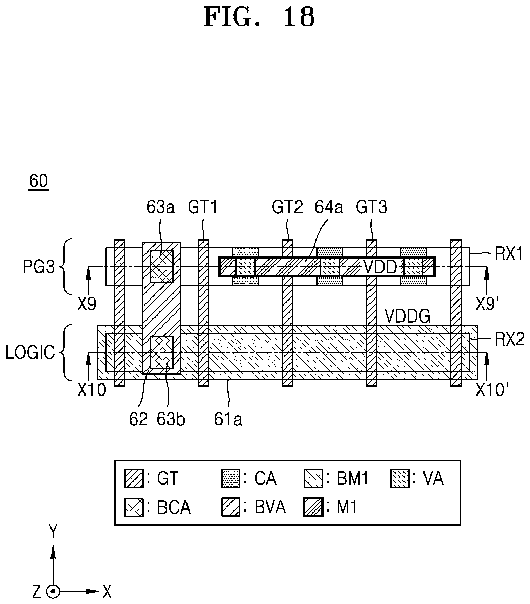

FIG. 18 shows a layout of an integrated circuit 60 according to one or more embodiments.

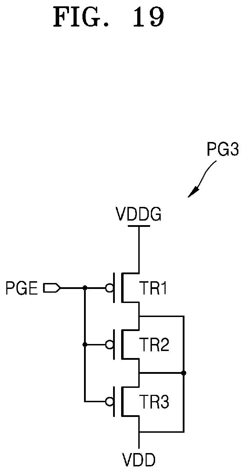

Referring to FIG. 18, the integrated circuit 60 may include active regions RX1 and RX2, gate line structures GT, contacts CA, vias VA, a frontside wiring layer M1, backside contacts BCA, a backside via BVA, and a backside wiring layer BM1. The integrated circuit 60 may correspond to a modification of the integrated circuit 10 of FIG. 1 or the integrated circuit 20 of FIG. 4, and may further include the contacts CA, the vias VA, the frontside wiring layer M1, and the backside contact BVA, compared to the integrated circuit 20 of FIG. 4. According to one or more embodiments, the integrated circuit 60 may include a power gating switch PG3 implemented with the active region RX1 and gate line structures GT1, GT2, and GT3, and the power gating switch PG3 may correspond to the power gating switch PG3 of FIG. 19. The integrated circuit 60 may further include a logic transistor, for example, a P-type transistor PFET, implemented in the active region RX2. The power gating switch PG3 is described below with reference to FIG. 19.

FIG. 19 is a circuit diagram of the power gating switch PG3 according to one or more embodiments.

Referring to FIGS. 18 and 19 together, the power gating switch PG3 may include first, second, and third transistors TR1, TR2, and TR3 connected with each other in series. The active region RX1 and the gate line structure GT1 may form the first transistor TR1, the active region RX1 and the gate line structure GT2 may form the second transistor TR2, and the active region RX1 and the gate line structure GT3 may form the third transistor TR3. Further, the second and third transistors TR2 and TR3 may be used as dummy transistors.

The first transistor TR1 may include a source receiving a first supply voltage, such as a global power supply voltage VDDG, a gate receiving a power gating signal PGE, and a drain providing a second supply voltage, such as a virtual power supply VDD. Respective gates of the second and third transistors TR2 and TR3 may receive the power gating signal PGE. A source and a drain of the second transistor TR2 may be commonly connected to the drain of the first transistor TR1. A source and a drain of the third transistor TR3 may be commonly connected to the drain of the first transistor TR1.

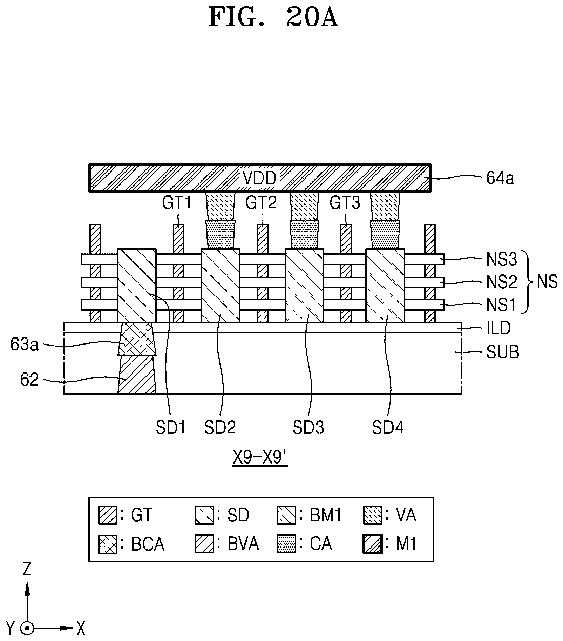

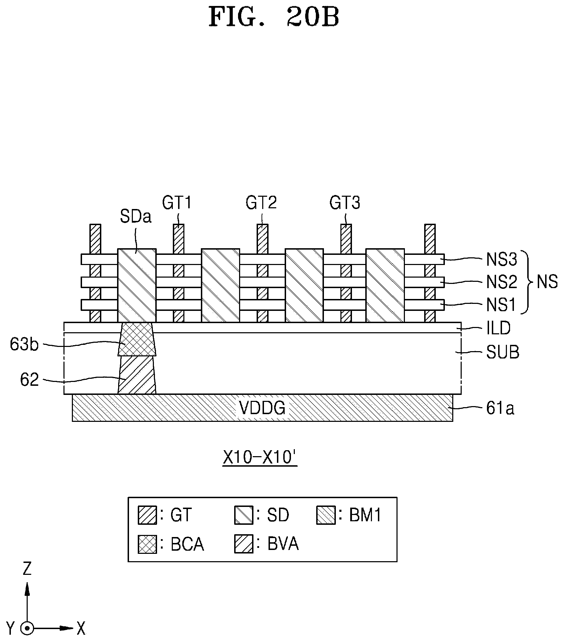

FIG. 20A is a cross-sectional view taken along line X9-X9' of FIG. 18 according to one or more embodiments, and FIG. 20B is a cross-sectional view taken along line X10-X10' of FIG. 18 according to one or more embodiments.

Referring to FIGS. 18 through 20B together, the backside wiring layer BM1 may include a backside pattern 61a extending in the first direction X below the substrate SUB. The first backside via BVA may be disposed on the backside wiring layer BM1 and may include a first backside via 62 extending in the second direction Y. The backside contacts BCA may be disposed on the first backside via 62 and include backside contacts 63a and 63b spaced apart from each other in the second direction Y. The contacts CA may be placed above the active region RX1. The vias VA may be respectively disposed on the contacts CA. The frontside wiring layer M1 may include a frontside pattern 64a extending in the first direction X.

The first backside via 62 may extend in the second direction Y on the backside pattern 61a. For example, the first backside via 62 may be at least partially overlapped by the active regions RX1 and RX2. The backside contact 63a may be placed between the first backside via 62 and a source/drain region SD1 of the active region RX1, and the backside contact 63b may be placed between the first backside via 62 and a source/drain region SDa of the active region RX2. The source/drain region SDa may be electrically connected to the first backside pattern 61a through the backside contact 63a and the backside via 62 and may receive the first supply voltage, for example, the global supply voltage VDDG, from the first backside pattern 61a.

The contacts CA may be arranged on source/drain region SD2, SD3, and SD4 of the active region RX1, respectively. The frontside pattern 64a may be electrically connected to the source/drain regions SD2, SD3, and SD4 through the vias VA and the contacts CA. The source/drain regions SD2, SD3, and SD4 may transfer the second supply voltage, e.g., the virtual power supply voltage VDD, to the frontside pattern 64a through the contacts CA and the vias VA.

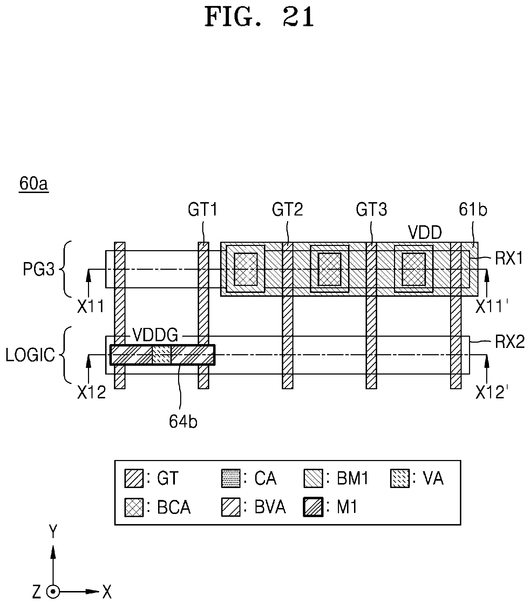

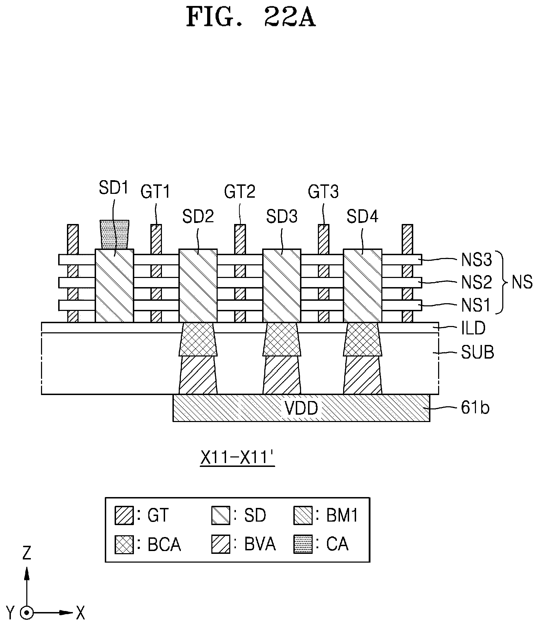

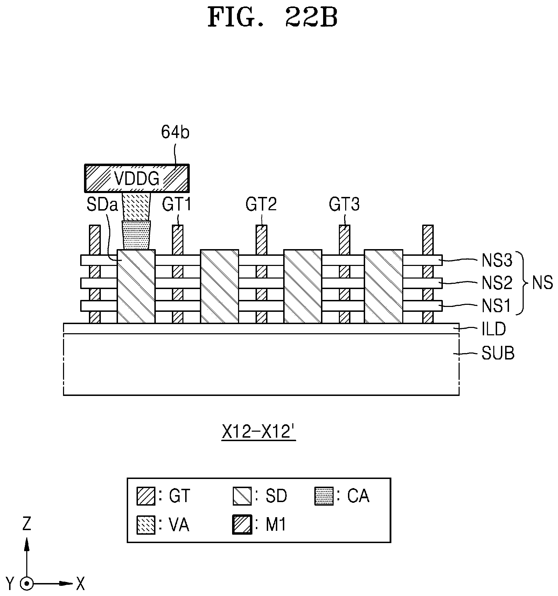

FIG. 21 shows a layout of an integrated circuit 60a according to one or more embodiments. FIG. 22A is a cross-sectional view taken along line X11-X11' of FIG. 21 according to one or more embodiments, and FIG. 22B is a cross-sectional view taken along line X12-X12' of FIG. 21 according to one or more embodiments.

Referring to FIGS. 21 through 22B together, the integrated circuit 60a may correspond to a modification of the integrated circuit 60 of FIG. 18. The backside wiring layer BM1 may include a backside pattern 61b extending in the first direction X, and the frontside wiring layer M1 may include a frontside pattern 64b extending in the first direction X. The contact CA may extend in the second direction Y above the substrate SUB. The contact CA may at least partially overlap the active regions RX1 and RX2. The contact CA may receive the first supply voltage, for example, the global power supply voltage VDDG, from the frontside pattern 64b through the via VA. The source/drain region SDa of the active region RX2 may be electrically connected to the frontside pattern 64b through the contact CA and the via VA.

The backside vias BVA may be disposed on the backside pattern 61b, and may be spaced apart from each other in the first direction X. The backside contacts BCA may be disposed on the backside vias BVA, respectively. Accordingly, the source/drain regions SD2, SD3, and SD4 may be electrically connected to the backside pattern 61b through the backside contacts BCA and the backside vias BVA. The source/drain regions SD2, SD3, and SD4 may transfer the second supply voltage, e.g., the virtual power supply voltage VDD, to the backside pattern 61b through the backside contacts BCA and the backside vias BVA.

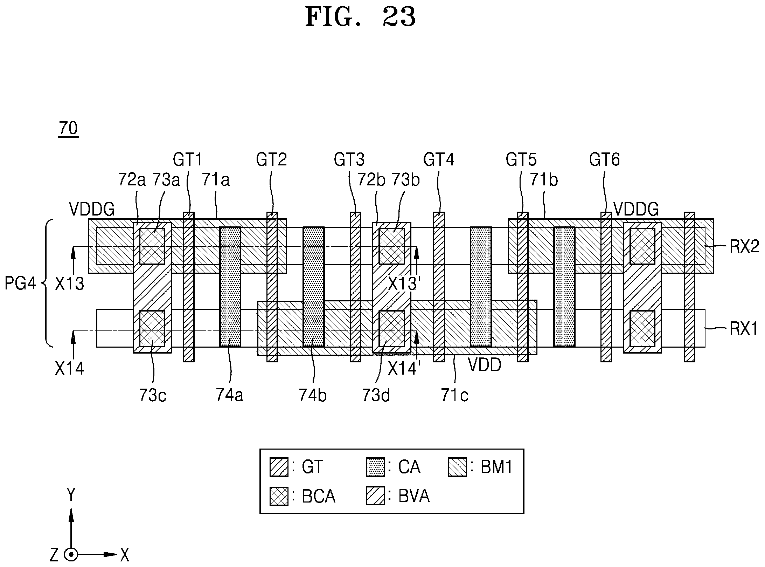

FIG. 23 shows a layout of an integrated circuit 70 according to one or more embodiments.

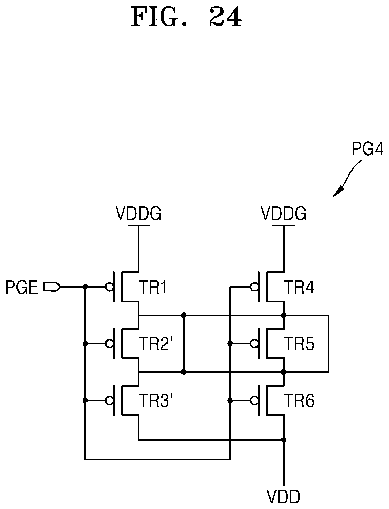

Referring to FIG. 23, the integrated circuit 70 may include active regions RX1 and RX2, gate line structures GT, contacts CA, backside contacts BCA, backside vias BVA, and a backside wiring layer BM1. The integrated circuit 70 may correspond to a modification of the integrated circuit 10 of FIG. 1 or the integrated circuit 20 of FIG. 4 and may further include the contacts CA, compared to the integrated circuit 20 of FIG. 4. According to one or more embodiments, the integrated circuit 70 may include a power gating switch PG4 implemented with the active regions RX1 and RX2 and gate line structures GT1 through GT4, and the power gating switch PG4 may correspond to a power gating switch PG4 of FIG. 24. The power gating switch PG4 is described below with reference to FIG. 24.

FIG. 24 is a circuit diagram of the power gating switch PG4 according to one or more embodiments.

Referring to FIGS. 23 and 24 together, the power gating switch PG4 may include first, second, and third transistors TR1, TR2', and TR3' connected with each other in series, and fourth, fifth, and sixth transistors TR4, TR5, and TR6 connected with each other in series. The active regions RX1 and RX2 and the gate line structure GT1 may form the first transistor TR1, the active regions RX1 and RX2 and the gate line structure GT2 may form the second transistor TR2', and the active region RX1 and the gate line structure GT3 may form the third transistor TR3'. Further, the active regions RX1 and RX2 and the gate line structure GT6 may form the fourth transistor TR4, the active regions RX1 and RX2 and the gate line structure GT5 may form the fifth transistor TR5, and the active region RX1 and the gate line structure GT4 may form the sixth transistor TR6.

The first through sixth transistors TR1 through TR6 may be driven according to the power gating signal PGE. Each of the first and fourth transistors TR1 and TR4 may include a source that receives the first supply voltage, for example, the global power supply voltage VDDG. Respective drains of the first and fourth transistors TR1 and TR4 may be electrically connected to each other. The source and drain of the second transistor TR2' may be commonly connected to the drain of the first transistor TR1, and the source and drain of the fifth transistor TR5 may be commonly connected to the drain of the fourth transistor TR4. Respective drains of the second and fifth transistors TR2' and TR5 may be electrically connected to each other. Accordingly, the second and fifth transistors TR2' and TR5 may be used as dummy transistors. Each of the third and sixth transistors TR3 and TR6 may include a drain that provides the second supply voltage, for example, the virtual power supply voltage VDD.

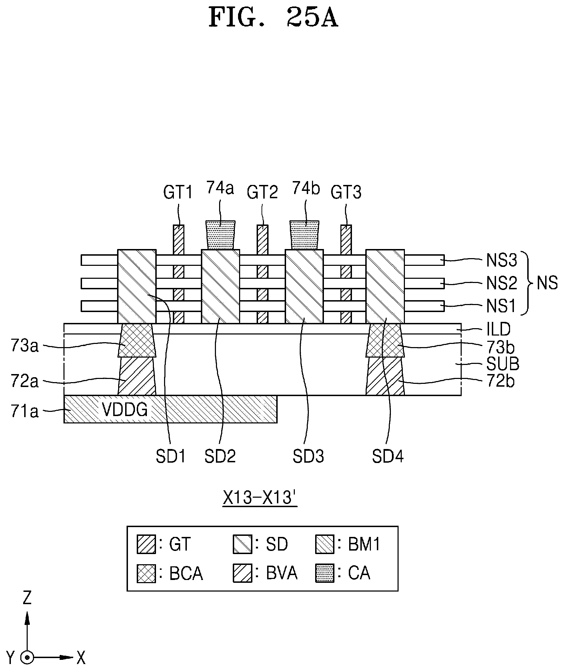

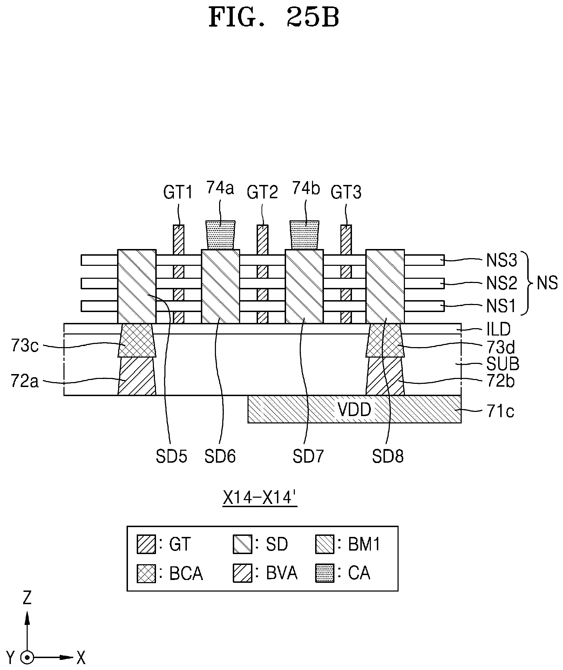

FIG. 25A is a cross-sectional view taken along line X13-X13' of FIG. 23 according to one or more embodiments, and FIG. 25B is a cross-sectional view taken along line X14-X14' of FIG. 23 according to one or more embodiments.

Referring to FIGS. 23 through 25B together, the backside wiring layer BM1 may include backside patterns 71a through 71c each extending in the first direction X below the substrate SUB. The backside vias BVA may be disposed on the backside wiring layer BM1, and may include backside vias 72a and 72b. The backside contacts BCA may be disposed on the back vias BVA, and, for example, may include backside contacts 73a and 73c spaced apart from each other in the second direction Y on the backside via 72a and backside contacts 73b and 73d spaced apart from each other in the second direction Y on the backside via 72b. The contacts CA may be disposed above the active regions RX1 and RX2, and may include, for example, contacts 74a and 74b.

The backside pattern 71a may receive the first supply voltage, for example, the global power supply voltage VDDG. The backside via 72a may be disposed on the backside pattern 71a, and may extend in the second direction Y. The backside contact 73a may be placed between the backside via 72a and a source/drain region SD1 of the active region RX2, and the backside contact 73c may be placed between the backside via 72a and a source/drain region SD5 of the active region RX1. The source/drain region SD1 may be electrically connected to the backside pattern 71a through the backside contact 73a and the backside via 72a, and may receive the first supply voltage from the backside pattern 71a. The source/drain region SD5 may be electrically connected to the backside pattern 71a through the backside contact 73c and the backside via 72a, and may receive the first supply voltage from the backside pattern 71a. For example, the source of the first transistor TR1 may receive the global power voltage VDDG from the backside pattern 71a.

The contact 74a may extend in the second direction Y and may be electrically connected to the source/drain regions SD2 and SD6. The contact 74a may extend in the second direction Y and may be electrically connected to the source/drain regions SD3 and SD7. The source/drain region SD8 may be electrically connected to the backside pattern 71c through the backside contact 73d and the backside via 72b, and may transfer the second supply voltage from the backside pattern 71c. For example, the drain of the third transistor TR3 may transfer the virtual power voltage VDD from the backside pattern 71c.

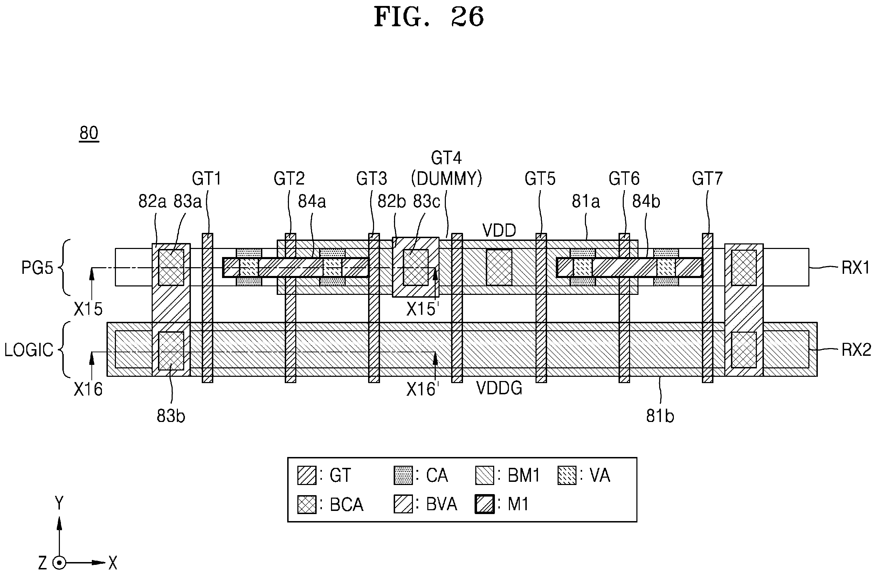

FIG. 26 shows a layout of an integrated circuit 80 according to one or more embodiments.

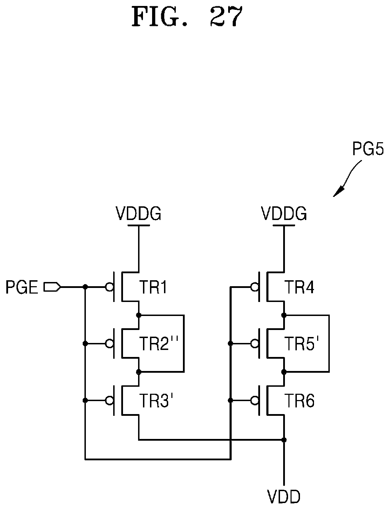

Referring to FIG. 26, the integrated circuit 80 may include active regions RX1 and RX2, gate line structures GT, contacts CA, vias VA, a frontside wiring layer M1, backside contacts BCA, backside vias BVA, and a backside wiring layer BM1. The integrated circuit 80 may correspond to a modification of the integrated circuit 10 of FIG. 1 or the integrated circuit 20 of FIG. 4 and may further include the contacts CA, the vias VA, and the frontside wiring layer M1, compared to the integrated circuit 20 of FIG. 4. According to one or more embodiments, the integrated circuit 80 may include a power gating circuit or power gating switch PG5 implemented with the active region RX1 and gate line structures GT1, GT2, GT3, GT4, GT5, GT6, and GT7, and the power gating switch PG5 may correspond to a power gating switch PG5 of FIG. 27. The integrated circuit 80 may further include a logic transistor LOGIC, for example, a P-type transistor PFET, implemented in the active region RX2. The power gating switch PG5 is described below with reference to FIG. 27.

FIG. 27 is a circuit diagram of the power gating switch PG5 according to one or more embodiments.

Referring to FIG. 27, the power gating switch PG5 may include first, second, and third transistors TR1, TR2", and TR3' connected with each other in series, and fourth, fifth, and sixth transistors TR4, TR5', and TR6 connected with each other in series. The active region RX1 and the gate line structure GT1 may form the first transistor TR1, the active region RX1 and the gate line structure GT2 may form the second transistor TR2", and the active region RX1 and the gate line structure GT3 may form the third transistor TR3'. Further, the active regions RX1 and RX2 and the gate line structure GT7 may form the fourth transistor TR4, the active region RX1 and the gate line structure GT6 may form the fifth transistor TR5', and the active region RX1 and the gate line structure GT5 may form the sixth transistor TR6. In this case, the gate line structure GT4 may correspond to a dummy gate line structure.

The first through sixth transistors TR1 through TR6 may be driven according to the power gating signal PGE. Each of the first and fourth transistors TR1 and TR4 may include a source that receives the first supply voltage, for example, the global power supply voltage VDDG. A source and drain of the second transistor TR2" may be commonly connected to the drain of the first transistor TR1, and a source and drain of the fifth transistor TR5' may be commonly connected to a drain of the fourth transistor TR4. Accordingly, the second and fifth transistors TR2" and TR5' may be used as dummy transistors. Each of the third and sixth transistors TR3 and TR6 may include a drain that provides the second supply voltage, for example, the virtual power supply voltage VDD.

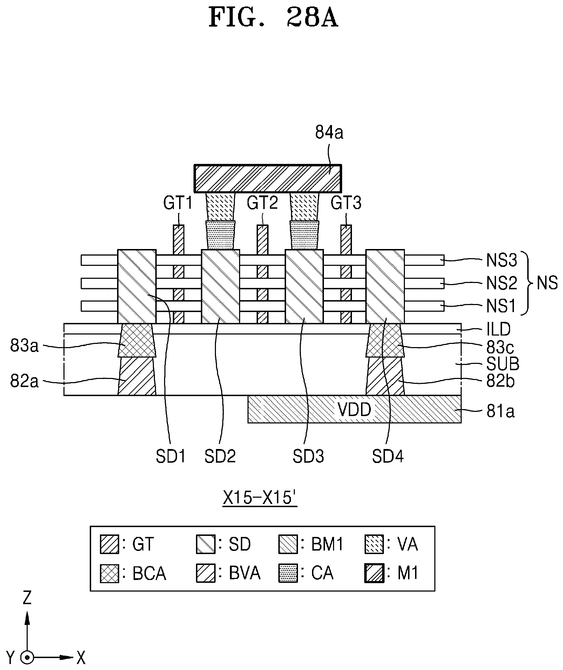

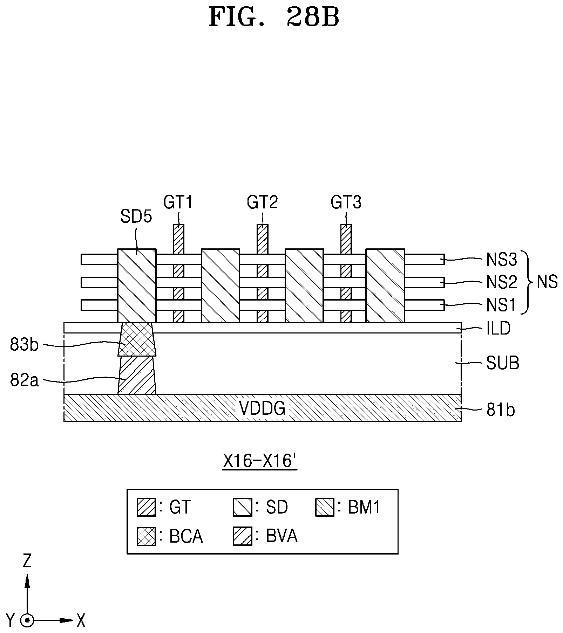

FIG. 28A is a cross-sectional view taken along line X15-X15' of FIG. 26 according to one or more embodiments, and FIG. 28B is a cross-sectional view taken along line X16-X16' of FIG. 26 according to one or more embodiments.

Referring to FIGS. 26 through 28B together, the backside wiring layer BM1 may include backside patterns 81a and 81b each extending in the first direction X below the substrate SUB. The backside vias BVA may be disposed on the backside wiring layer BM1, and may include backside vias 82a and 82b. The backside contacts BCA may be disposed on the backside vias BVA, and, for example, may include backside contacts 83a and 83b spaced apart from each other in the second direction Y on the backside via 82a and a backside contact 83c on the backside via 82b. The contacts CA may be placed above the active region RX1. The frontside wiring layer M1 may include frontside patterns 85a and 85b each extending in the first direction X and spaced apart from each other in the first direction X.

The backside pattern 81b may receive the first supply voltage, for example, the global power supply voltage VDDG. The backside via 82a may be disposed on the backside pattern 81b, and may extend in the second direction Y. The backside contact 83a may be placed between the backside via 82a and a source/drain region SD1 of the active region RX1, and the backside contact 83b may be placed between the backside via 82a and a source/drain region SD5 of the active region RX2. The source/drain region SD1 may be electrically connected to the backside pattern 81b through the backside contact 83a and the backside via 82a, and may receive the first supply voltage from the backside pattern 81b. For example, the source of the first transistor TR1 may receive the global power voltage VDDG from the backside pattern 81b.

The source/drain regions SD2 and SD3 may be electrically connected to the frontside pattern 84a through the contacts CA and the vias VA. As such, the source/drain regions SD2 and SD3 may be electrically connected to each other through a FSPDN. The source/drain region SD4 may be electrically connected to the backside pattern 81a through the backside contact 83c and the backside via 82b. A drain of the third transistor TR3' may transfer the second supply voltage, for example, the virtual power voltage VDD, to the backside pattern 81a.

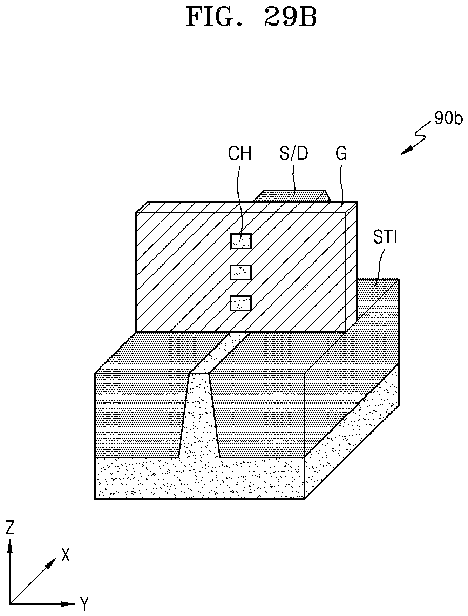

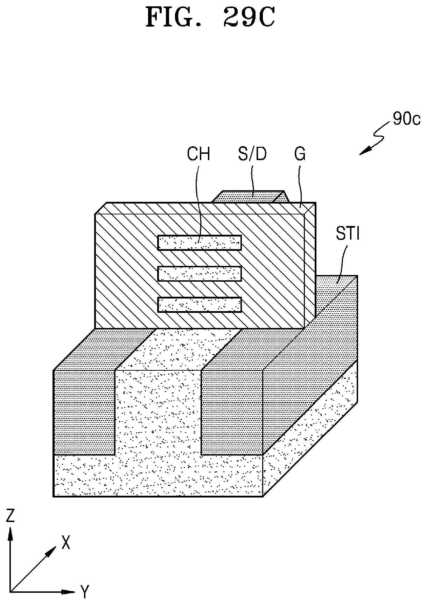

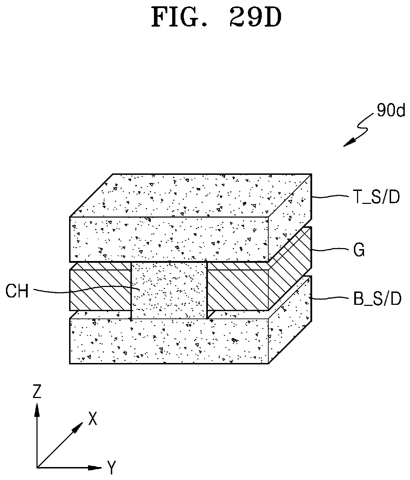

FIGS. 29A through 29D are diagrams showing devices according to one or more embodiments. For example, FIG. 29A shows a fin field-effect transistor (FinFET) 90a, FIG. 29B shows a gate-all-around field effect transistor (GAAFET) 90b, FIG. 29C shows a multi-bridge channel field effect transistor (MBCFET) 90c, and FIG. 29D shows a vertical field effect transistor (VFET) 90d. For convenience of illustration, FIGS. 29A through 29C show structures in which one of two source/drain regions is removed, and FIG. 29D shows a cross-section of the VFET 90d cut along a plane parallel to another plane consisting of the second direction Y and the vertical direction Z and passing through a channel CH of the VFET 90d.

Referring to FIG. 29A, the FinFET 90a may be formed by a fin-shaped active pattern extending in the first direction X between STIs and a gate G extending in the second direction Y. Source/drains S/D may be formed on both sides of the gate G, and accordingly, the source and drains (S/D) may be spaced apart from each other in the first direction X. An insulation layer may be formed between the channel CH and the gate G. According to one or more other embodiments, the FinFET 90a may be formed by a plurality of active patterns spaced apart from each other in the second direction Y and the gate G. For example, the FinFET 90a may be included in the integrated circuits 10 through 80 of FIGS. 1 through 28B. The power gating switches included in the integrated circuits 10 through 80 of FIGS. 1 through 28B may be implemented by one or more of the FinFET 90a.

Referring to FIG. 29B, the GAAFET 90b may be formed by active patterns (i.e., nanowires) each extending in the first direction X and spaced apart from each other in the vertical direction Z and a gate G extending in the second direction Y. Source/drains S/D may be formed on both sides of the gate G, and accordingly, the source and drains S/D may be spaced apart from each other in the first direction X. An insulation layer may be formed between the channel CH and the gate G. The number of nanowires included in the GAAFET 90b is not limited to the number of nanowires shown in FIG. 29B. For example, the GAAFET 90b may be included in the integrated circuits 10 through 80 of FIGS. 1 through 28B. The power gating switches included in the integrated circuits 10 through 80 of FIGS. 1 through 28B may be implemented like the GAAFET 90b.

Referring to FIG. 29C, the MBCFET 90c may be formed by active patterns (i.e., nanosheets) each extending in the first direction X and spaced apart from each other in the vertical direction Z and a gate G extending in the second direction Y. Source/drains S/D may be formed on both sides of the gate G, and accordingly, the source and drains S/D may be spaced apart from each other in the first direction X. An insulation layer may be formed between the channel CH and the gate G. The number of nanosheets included in the MBCFET 90c is not limited to the number of nanosheets shown in FIG. 29C. For example, the MBCFET 90c may be included in the integrated circuits 10 through 80 of FIGS. 1 through 28B. For example, power gating switches included in the integrated circuits 10 through 80 of FIGS. 1 through 28B may be implemented like the MBCFET 90c.

Referring to FIG. 29D, the VFET 90d may include a top source/drain T_SD and a bottom source/drain B_SD spaced apart from each other in the vertical direction Z with the channel CH therebetween. The VFET 90d may include a gate G surrounding the circumference of the channel CH between the top source/drain T_SD and the bottom source/drain B_SD. An insulation layer may be formed between the channel CH and the gate G. For example, the VFET 90d may be included in the integrated circuits 10 through 80 of FIGS. 1 through 28B. The power gating switches included in the integrated circuits 10 through 80 of FIGS. 1 through 28B may be implemented like the VFET 90d.

However, the transistors according to the above embodiments are not limited to the above-described structure. For example, an integrated circuit may include a Forksheet FET having a structure in which nano-sheets for a P-type transistor and nano-sheets for an N-type transistor are separated from each other by a dielectric wall, and thus an N-type transistor and a P-type transistor are closer to each other. The integrated circuit may include bipolar junction transistors as well as FETs, such as a complementary field effect transistor (CFET), a negative capacitance field effect transistor (NCFET), and a carbon nanotube (CNT) FET.

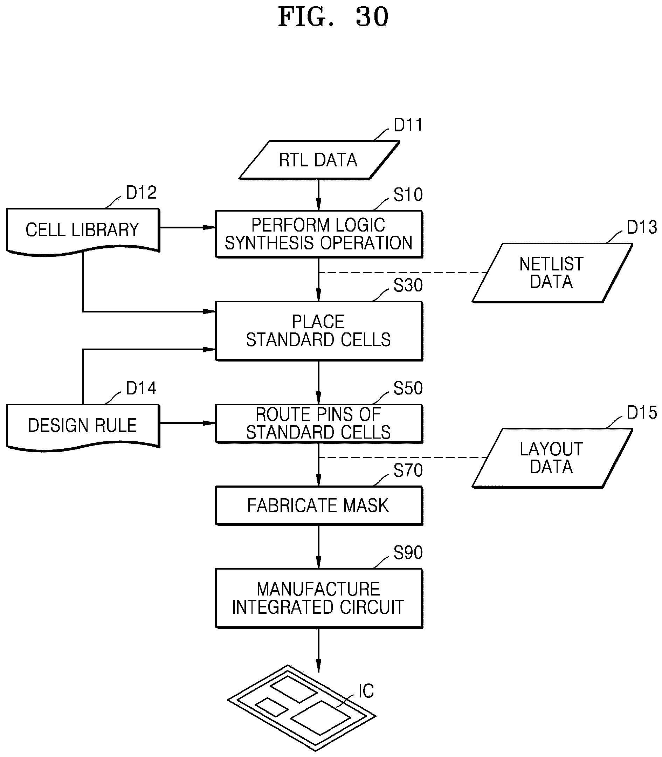

FIG. 30 is a flowchart of a method of manufacturing an integrated circuit, according to one or more embodiments. Referring to FIG. 30, the method according to the present embodiments is a method of manufacturing an integrated circuit IC including standard cells, and may include a plurality of operations, namely, operation S10, operation S30, operation S50, operation S70, and operation S90. A cell library D12 (or a standard cell library) may include information about standard cells, for example, information about functions, characteristics, a layout, and the like of the standard cells. According to some embodiments, the cell library D12 may define tap cells and dummy cells as well as function cells generating output signals from input signals. According to some embodiments, the cell library D12 may define memory cells and dummy cells having the same footprint. A design rule D14 may include requirements that the layout of the integrated circuit IC need to comply with. For example, the design rule D14 may include requirements for a space between patterns in the same layer, a minimum width of a pattern, a routing direction of a wiring layer, and the like. According to some embodiments, the design rules D14 may define a minimum spacing within the same track of the wiring layer.

In operation S10, a logic synthesis operation may be performed to generate netlist data D13 from register-transfer level (RTL) data D11. For example, a semiconductor design tool (for example, a logic synthesis tool) may perform a logic synthesis with reference to the cell library D12 from the RTL data D11 written in a Hardware Description Language (HDL) such as VHSIC Hardware Description Language (VHDL) and Verilog, and may generate the netlist data D13 including a bitstream or a netlist. The netlist data D13 may correspond to an input of placing and routing which will be described later.

In operation S30, the standard cells may be placed. For example, a semiconductor design tool (for example, a placing and routing (P&R) tool) may place standard cells used by the netlist data D13, by referring to the cell library D12. According to some embodiments, the semiconductor design tool may place the standard cells in a row extending in an X-axis direction or a Y-axis direction, and the placed standard cells may receive power from power rails extending along boundaries of the row.

In operation S50, pins of the standard cells may be routed. For example, the semiconductor design tool may generate interconnections electrically connecting output pins and input pins of the placed standard cells to each other, and may generate layout data D15 defining the placed standard cells and the generated interconnections. An interconnection may include via in a via layer and/or patterns of wiring layers. The wiring layers may include a frontside wiring layer disposed above the front side of a substrate and a backside wiring layer disposed on the back side of the substrate. The layout data D15 may have a format such as GDSII, and may include geometric information about the standard cells and geometric information about the interconnections. The semiconductor design tool may refer to the design rule D14 while routing the pins of the standard cells. The layout data D15 may correspond to an output of the placing and routing. Operation S50 alone, or operations S30 and S50 collectively, may be referred to as a method of designing an integrated circuit.

The integrated circuits 10 through 80 of FIGS. 1 through 28B may include a backside wiring layer BM disposed on the backside of the substrate, where the backside wiring layer BM may be connected directly to a power gating switch placed on a front side of the substrate through a DBC including a backside via BVA and/or a backside contact BCA. Accordingly, the routing complexity of the frontside wiring layer disposed on the front side of the substrate may be reduced, and an IR drop between the backside wiring layer BM and a source/drain region may be reduced.

In operation S70, a mask may be fabricated. For example, optical proximity correction (OPC) for correcting a distortion phenomenon such as refraction caused due to the characteristics of light in photolithography may be applied to the layout data D15. Patterns on the mask may be defined to form patterns that are to be arranged in a plurality of layers according to OPC-applied data, and at least one mask (or photomask) for forming respective patterns of the plurality of layers may be fabricated. According to one or more other embodiments, the layout of the integrated circuit IC may be limitedly modified in operation S70, and the limited modification of the integrated circuit IC in operation S70 is a post-processing for optimizing the structure of the integrated circuit IC, and may be referred to as design polishing.

In operation S90, the integrated circuit IC may be manufactured. For example, the integrated circuit IC may be manufactured by patterning the plurality of layers by using the at least one mask fabricated in operation S70. A front-end-of-line (FEOL) may include, for example, an operation of planarizing and cleaning a wafer, an operation of forming a trench, an operation of forming a well, an operation of forming a gate line structure, and an operation of forming a source and a drain. Individual devices, such as a transistor, a capacitor, a resistor, and the like, may be formed on a substrate by the FEOL. A back-end-of-line (BEOL) may include, for example, an operation of performing silicidation of a gate, a source region, and a drain region, an operation of adding a dielectric, a planarization operation, an operation of forming a hole, an operation of adding a metal layer, an operation of forming a via, and an operation of forming a passivation layer. Individual devices, such as a transistor, a capacitor, a resistor, and the like, may be interconnected to each other by the BEOL. According to some embodiments, a middle-of-line (MOL) may be performed between the FEOL and the BEOL, and contacts may be formed on individual devices. Moreover, a backside process may be performed on a back side of the substrate to form one or more of a backside wiring layer, a backside via, and a backside contact. Next, the integrated circuit IC may be packaged into a semiconductor package and may be used as a component part of various applications.

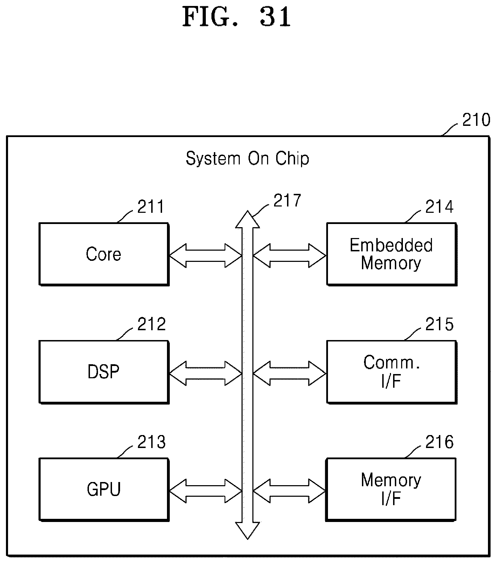

FIG. 31 is a block diagram of a system on chip (SoC) 210 according to one or more embodiments. Referring to FIG. 31, the SoC 210 may refer to as an integrated circuit in which component parts of a computing system or other electronic systems are integrated. For example, an application processor (AP) as an example of the SoC 210 may include a processor and components for other functions. The SoC 210 may include a core 211, a digital signal processor (DSP) 212, a graphics processing unit (GPU) 213, an embedded memory 214, a communication interface (I/F) 215, and a memory I/F 216. The components of the SoC 210 may communicate with each other via a bus 217.

The core 211 may process instructions, and may control operations of the components included in the SoC 210. For example, the core 211 may drive an operating system and execute applications on the operating system, by processing a series of instructions. The DSP 212 may generate useful data by processing a digital signal, e.g., a digital signal provided from the communication I/F 215. The GPU 213 may generate data for an image output through a display device from image data provided by the embedded memory 214 or the memory I/F 216, and may encode the image data. According to some embodiments, the integrated circuit described above with reference to the drawings may be included in the core 211, the DSP 212, the GPU 213, and/or the embedded memory 214.

The embedded memory 214 may store data necessary for operations of the core 211, the DSP 212, and the GPU 213. The communication I/F 215 may provide an interface for a communication network or one-to-one communication. The memory I/F 216 may provide an interface for an external memory of the SoC 210, such as dynamic random access memory (DRAM) or flash memory.

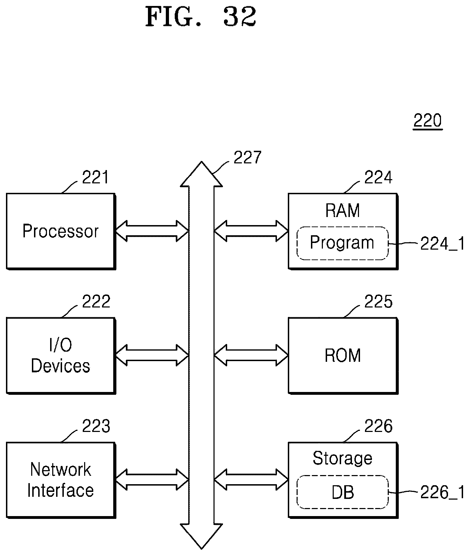

FIG. 32 is a block diagram of a computing system 220 including a memory that stores a program, according to one or more embodiments. Referring to FIG. 32, at least some of the operations included in a method of designing an integrated circuit according to embodiments, for example, the operations of the above-described flowchart, may be performed in the computing system 220 (or a computer). The computing system 220 may include a processor 221, input/output (I/O) devices 222, a network interface 223, a random access memory (RAM) 224, a read only memory (ROM) 225, and a storage 226. The processor 221, the I/O devices 222, the network interface 223, the RAM 224, the ROM 225, and the storage 226 may be connected to a bus 227 and may communicate with each other via the bus 227.

The processor 221 may be referred to as a processing unit, and may include at least one core capable of executing any instruction set (e.g., Intel Architecture-32 (IA-32), 64-bit extension IA-32, x86-64, PowerPC, Sparc, MIPS, ARM, and IA-64), like a microprocessor, an AP, a DSP, or a GPU. For example, the processor 221 may access a memory, namely, the RAM 224 or the ROM 225, via the bus 227, and may execute the instructions stored in the RAM 224 or the ROM 225.

The RAM 224 may store a program 224_1 for a method of designing an integrated circuit or at least a portion of the program 224_1, and the program 224_1 may enable the processor 221 to perform at least some of the operations included in the method of designing the integrated circuit, for example, the operations of FIG. 30. In other words, the program 224_1 may include a plurality of instructions executable by the processor 221, and the plurality of instructions included in the program 224_1 may enable the processor 221 to perform, for example, at least some of the operations included in the above-described flowchart.

The storage 226 may not lose stored data even when power supplied to the computing system 220 is cut off. The storage 226 may store the program 224_1, and, before the program 224_1 is executed by the processor 221, the program 224_1 or at least a portion thereof from the storage 226 may be loaded into the RAM 224. Alternatively, the storage 226 may store a file written in a programming language, and a program 224_1 generated from the file by a compiler or the like or at least a portion of the program 224_1 may be loaded into the RAM 224. The storage 226 may also store a database (DB) 226_1, and the DB 226_1 may include information necessary for designing the integrated circuit, for example, information about designed blocks, the cell library D12 of FIG. 30, and/or the design rule D14 of FIG. 30.

The storage 226 may store data that is to be processed by the processor 221, or data processed by the processor 221. In other words, according to the program 224_1, the processor 221 may generate data by processing the data stored in the storage 226, and may store the generated data in the storage 226. For example, the storage 226 may store the RTL data D11, the netlist data D13, and/or the layout data D15 of FIG. 30.

The I/O devices 222 may include an input device, such as a keyboard or a pointing device, and an output device, such as a printer or a display. For example, through the I/O devices 222, a user may trigger the execution of the program 224_1 by the processor 221, may input the RTL data D11 and/or the netlist data D13 of FIG. 30, and may check the layout data D15 of FIG. 30. The network interface 223 may provide access to a network outside the computing system 220. For example, the network may include multiple computing systems and communication links, and the communication links may include wired links, optical links, wireless links, or any other type of links.

## Claims

1. An integrated circuit (10, 20, 20a, 30, 40, 40a, 40b, 50, 50a, 60, 60a, 70, 80) comprising:
a backside wiring layer (BM1) on a backside (BS) of a substrate (SUB), the backside wiring layer (BM1) comprising a first backside pattern (11a) and a second backside pattern (11b) isolated from each other;
a first backside contact (13a) on the first backside pattern (11a);
a second backside contact (13b) on the second backside pattern (11b); and
a power gating switch (PG1) on a front side (FS) of the substrate (SUB), the power gating switch (PG1) connected to the first and second backside patterns (11a, 11b),
wherein the power gating switch (PG1) comprises:
a first source/drain region (SD1) connected to the first backside pattern (11a) through a first backside via (12a) and the first backside contact (13a), and configured to receive a first supply voltage (VDDG) from the first backside pattern (11a);
a gate line structure (GT) configured to receive a power gating signal (PGE); and
a second source/drain region (SD2) connected to the second backside pattern (11b) through a second backside via (12b) and the second backside contact (13b), and configured to receive a power signal from the first source/drain region (SD1) based on the power gating signal (PGE).

2. The integrated circuit (10, 20, 20a, 30, 40, 40a, 40b, 50, 50a, 60, 60a, 70, 80) of claim 1, wherein, based on the power gating signal (PGE) being at an enable level, the second source/drain region (SD2) of the power gating switch (PG1) is configured to provide a second supply voltage (VDD) to the second backside pattern (11b) based on the power signal.

3. The integrated circuit (10, 20, 20a, 30, 40, 40a, 40b, 50, 50a, 60, 60a, 70, 80) of claim 2, wherein the first supply voltage (VDDG) corresponds to a global supply voltage or an external supply voltage, and
wherein the second supply voltage (VDD) corresponds to a virtual supply voltage or an internal supply voltage.

4. The integrated circuit (10, 20, 20a, 30, 40, 40a, 40b, 50, 50a, 60, 60a, 70, 80) of any one of claims 1 to 3, further comprising:
wherein the first backside via (12a) is between the first backside contact (13a) and the first backside pattern (11a); and
wherein the second backside via (12b) is between the second backside contact (13b) and the second backside pattern (11b).

5. The integrated circuit (10, 20, 20a, 30, 40, 40a, 40b, 50, 50a, 60, 60a, 70, 80) of claim 1, wherein the backside wiring layer (BM1) further comprises a third backside pattern (11c) isolated from the first and second backside patterns (11a, 11b),
wherein the first backside pattern (11a) and the third backside pattern (11c) are connected, and
wherein the first source/drain region (SD1) of the power gating switch (PG1) is configured to receive the first supply voltage from the third backside pattern (11c).

6. The integrated circuit (10, 20, 20a, 30, 40, 40a, 40b, 50, 50a, 60, 60a, 70, 80) of claim 1, wherein the backside wiring layer (BM1) further comprises a third backside pattern (11c) spaced apart from the first and second backside patterns (11a, 11b),
wherein the second backside pattern (11b) and the third backside pattern (11c) are connected, and
wherein the integrated circuit (10, 20, 20a, 30, 40, 40a, 40b, 50, 50a, 60, 60a, 70, 80) further comprises a third source/drain region (SD3) configured to receive the second supply voltage through the third backside pattern (11c).

7. The integrated circuit (10, 20, 20a, 30, 40, 40a, 40b, 50, 50a, 60, 60a, 70, 80) of claim 1, wherein the backside wiring layer (BM1) further includes a third backside pattern (11c) isolated from the second backside pattern (11b),
wherein the second backside pattern (11b) and the third backside pattern (11c) are connected, and
wherein the integrated circuit (10, 20, 20a, 30, 40, 40a, 40b, 50, 50a, 60, 60a, 70, 80) further comprises a third source/drain region (SD3) configured to receive the second supply voltage through the third backside pattern (11c).

8. The integrated circuit (10, 20, 20a, 30, 40, 40a, 40b, 50, 50a, 60, 60a, 70, 80) of any one of claims 1 to 7, further comprising a second backside wiring layer (BM2) below the backside wiring layer (BM1) in a vertical direction (Z),
wherein the second backside wiring layer (BM2) comprises:
a first backside wiring line connected to the first backside pattern (11a) and configured to receive the first supply voltage; and
a second backside wiring line connected to the second backside pattern (11b) and configured to receive the second supply voltage.

9. The integrated circuit (10, 20, 20a, 30, 40, 40a, 40b, 50, 50a, 60, 60a, 70, 80) of any one of claims 1 to 8, wherein the first backside contact (13a) passes through the substrate (SUB) in a vertical direction (Z) and is connected to the first source/drain region (SD1) of the power gating switch (PG1), and
the second backside contact (13b) passes through the substrate (SUB) in the vertical direction (Z) and is connected to the second source/drain region (SD2) of the power gating switch (PG1).

10. The integrated circuit (10, 20, 20a, 30, 40, 40a, 40b, 50, 50a, 60, 60a, 70, 80) of any one of claims 1 to 9, wherein the power gating switch (PG1) comprises a plurality of transistors (TR1-TR3) connected in parallel.

11. The integrated circuit (10, 20, 20a, 30, 40, 40a, 40b, 50, 50a, 60, 60a, 70, 80) of any one of claims 1 to 10, wherein:
the first backside pattern (11a) and the second backside pattern (11b) each extend in a first direction (X) and are isolated from each other in a second direction intersecting with the first direction (X),
the integrated circuit (10, 20, 20a, 30, 40, 40a, 40b, 50, 50a, 60, 60a, 70, 80) comprises a contact (13a-c, 33a, 33b, 63a, 63b, 73a-d, 74a, 74b, 83a-c) on the front side (FS) of the substrate (SUB), the contact (13a-c, 33a, 33b, 63a, 63b, 73a-d, 74a, 74b, 83a-c) extending in the second direction (Y), and
the first source/drain region (SD1) is configured to receive the first supply voltage from the first backside pattern (11a) through the contact (13a-c, 33a, 33b, 63a, 63b, 73a-d, 74a, 74b, 83a-c).

## Patentansprüche

1. Eine integrierte Schaltung (10, 20, 20a, 30, 40, 40a, 40b, 50, 50a, 60, 60a, 70, 80), umfassend:
eine Rückseitenverdrahtungsschicht (BM1) auf einer Rückseite (BS) eines Substrats (SUB), wobei die Rückseitenverdrahtungsschicht (BM1) ein erstes Rückseitenmuster (11a) und ein zweites Rückseitenmuster (11b) umfasst, die voneinander isoliert sind;
einen ersten Rückseitenkontakt (13a) auf dem ersten Rückseitenmuster (11a);
einen zweiten Rückseitenkontakt (13b) auf dem zweiten Rückseitenmuster (11b); und
ein Power-Gating-Schalter (PG1) auf einer Vorderseite (FS) des Substrats (SUB), wobei der Power-Gating-Schalter (PG1) mit dem ersten und dem zweiten Rückseitenmuster (11a, 11b) verbunden ist,
wobei der Power-Gating-Schalter (PG1) umfasst:
einen ersten Source-/Drain-Bereich (SD1), der über eine erste Rückseiten-Durchkontaktierung (12a) und den ersten Rückseitenkontakt (13a) mit dem ersten Rückseitenmuster (11a) verbunden ist und derart konfiguriert ist, dass er eine erste Versorgungsspannung (VDDG) vom ersten Rückseitenmuster (11a) empfängt;
eine Gate-Leitungsstruktur (GT), die derart konfiguriert ist, dass sie ein Power-Gating-Signal (PGE) empfängt; und
einen zweiten Source/Drain-Bereich (SD2), der über eine zweite Rückseiten-Durchkontaktierung (12b) und den zweiten Rückseitenkontakt (13b) mit dem zweiten Rückseitenmuster (11b) verbunden ist und derart konfiguriert ist, dass er ein Leistungssignal vom ersten Source/Drain-Bereich (SD1) auf der Grundlage des Power-Gating-Signals (PGE) empfängt.

2. Die integrierte Schaltung (10, 20, 20a, 30, 40, 40a, 40b, 50, 50a, 60, 60a, 70, 80) nach Anspruch 1, wobei auf der Grundlage des Power-Gating-Signals (PGE), das sich auf einem Freigabepegel befindet, der zweite Source-/Drain-Bereich (SD2) des Power-Gating-Schalters (PG1) derart konfiguriert ist, dass er auf der Grundlage des Leistungssignals eine zweite Versorgungsspannung (VDD) an das zweite Rückseitenmuster (11b) liefert.

3. Die integrierte Schaltung (10, 20, 20a, 30, 40, 40a, 40b, 50, 50a, 60, 60a, 70, 80) nach Anspruch 2, wobei die erste Versorgungsspannung (VDDG) einer globalen Versorgungsspannung oder einer externen Versorgungsspannung entspricht, und
wobei die zweite Versorgungsspannung (VDD) einer virtuellen Versorgungsspannung oder einer internen Versorgungsspannung entspricht.

4. Die integrierte Schaltung (10, 20, 20a, 30, 40, 40a, 40b, 50, 50a, 60, 60a, 70, 80) nach einem der Ansprüche 1 bis 3, die ferner umfasst:
wobei die erste Rückseiten-Durchkontaktierung (12a) zwischen dem ersten Rückseitenkontakt (13a) und dem ersten Rückseitenmuster (11a) angeordnet ist; und
wobei die zweite Rückseiten-Durchkontaktierung (12b) zwischen dem zweiten Rückseitenkontakt (13b) und dem zweiten Rückseitenmuster (11b) angeordnet ist.

5. Die integrierte Schaltung (10, 20, 20a, 30, 40, 40a, 40b, 50, 50a, 60, 60a, 70, 80) nach Anspruch 1, wobei die Rückseitenverdrahtungsschicht (BM1) ferner ein drittes Rückseitenmuster (11c) umfasst, das von dem ersten und zweiten Rückseitenmuster isoliert ist (11a, 11b) isoliert ist,
wobei das erste Rückseitenmuster (11a) und das dritte Rückseitenmuster (11c) miteinander verbunden sind, und
wobei der erste Source-/Drain-Bereich (SD1) des Power-Gating-Schalters (PG1) derart konfiguriert ist, dass er die erste Versorgungsspannung vom dritten Rückseitenmuster (11c) empfängt.

6. Die integrierte Schaltung (10, 20, 20a, 30, 40, 40a, 40b, 50, 50a, 60, 60a, 70, 80) nach Anspruch 1, wobei die Rückseitenverdrahtungsschicht (BM1) ferner ein drittes Rückseitenmuster (11c) umfasst, das von dem ersten und dem zweiten Rückseitenmuster (11a, 11b) beabstandet ist,
wobei das zweite Rückseitenmuster (11b) und das dritte Rückseitenmuster (11c) verbunden sind, und
wobei die integrierte Schaltung (10, 20, 20a, 30, 40, 40a, 40b, 50, 50a, 60, 60a, 70, 80) ferner einen dritten Source-/Drain-Bereich (SD3) umfasst, der derart konfiguriert ist, dass er die zweite Versorgungsspannung über das dritte Rückseitenmuster (11c) empfängt.

7. Die integrierte Schaltung (10, 20, 20a, 30, 40, 40a, 40b, 50, 50a, 60, 60a, 70, 80) nach Anspruch 1, wobei die Rückseitenverdrahtungsschicht (BM1) ferner ein drittes Rückseitenmuster (11c) umfasst, das von dem zweiten Rückseitenmuster (11b) isoliert ist,
wobei das zweite Rückseitenmuster (11b) und das dritte Rückseitenmuster (11c) verbunden sind, und
wobei die integrierte Schaltung (10, 20, 20a, 30, 40, 40a, 40b, 50, 50a, 60, 60a, 70, 80) ferner einen dritten Source-/Drain-Bereich (SD3) umfasst, der derart konfiguriert ist, dass er die zweite Versorgungsspannung über das dritte Rückseitenmuster (11c) empfängt.

8. Die integrierte Schaltung (10, 20, 20a, 30, 40, 40a, 40b, 50, 50a, 60, 60a, 70, 80) nach einem der Ansprüche 1 bis 7, ferner umfassend eine zweite Rückseitenverdrahtungsschicht (BM2) unterhalb der Rückseitenverdrahtungsschicht (BM1) in vertikaler Richtung (Z),
wobei die zweite Rückseitenverdrahtungsschicht (BM2) umfasst:
eine erste Rückseitenverdrahtungsleitung, die mit dem ersten Rückseitenmuster (11a) verbunden und derart konfiguriert ist, dass sie die erste Versorgungsspannung empfängt; und
eine zweite Rückseitenverdrahtungsleitung, die mit dem zweiten Rückseitenmuster (11b) verbunden und derart konfiguriert ist, dass sie die zweite Versorgungsspannung empfängt.

9. Die integrierte Schaltung (10, 20, 20a, 30, 40, 40a, 40b, 50, 50a, 60, 60a, 70, 80) nach einem der Ansprüche 1 bis 8, wobei der erste Rückseitenkontakt (13a) in vertikaler Richtung (Z) durch das Substrat (SUB) verläuft und mit dem ersten Source-/Drain-Bereich (SD1) des Power-Gating-Schalters (PG1) verbunden ist, und
der zweite Rückseitenkontakt (13b) das Substrat (SUB) in vertikaler Richtung (Z) durchdringt und mit dem zweiten Source-/Drain-Bereich (SD2) des Power-Gating-Schalters (PG1) verbunden ist.

10. Die integrierte Schaltung (10, 20, 20a, 30, 40, 40a, 40b, 50, 50a, 60, 60a, 70, 80) nach einem der Ansprüche 1 bis 9, wobei der Power-Gating-Schalter (PG1) mehrere parallel geschaltete Transistoren (TR1-TR3) umfasst.

11. Die integrierte Schaltung (10, 20, 20a, 30, 40, 40a, 40b, 50, 50a, 60, 60a, 70, 80) nach einem der Ansprüche 1 bis 10, wobei:
sich das erste Rückseitenmuster (11a) und das zweite Rückseitenmuster (11b) jeweils in einer ersten Richtung (X) erstrecken und in einer zweiten Richtung, die die erste Richtung (X) schneidet, voneinander isoliert sind,
die integrierte Schaltung (10, 20, 20a, 30, 40, 40a, 40b, 50, 50a, 60, 60a, 70, 80) einen Kontakt (13a-c, 33a, 33b, 63a, 63b, 73a-d, 74a, 74b, 83a-c) auf der Vorderseite (FS) des Substrats (SUB) umfasst, wobei sich der Kontakt (13a-c, 33a, 33b, 63a, 63b, 73a-d, 74a, 74b, 83a-c) erstreckt sich in der zweiten Richtung (Y), und
der erste Source-/Drain-Bereich (SD1) ist derart konfiguriert, dass er die erste Versorgungsspannung vom ersten Rückseitenmuster (11a) über den Kontakt (13a-c, 33a, 33b, 63a, 63b, 73a-d, 74a, 74b, 83a-c) empfängt.

## Revendications

1. Un circuit intégré (10, 20, 20a, 30, 40, 40a, 40b, 50, 50a, 60, 60a, 70, 80) comprenant :
une couche de câblage arrière (BM1) sur une face arrière (BS) d'un substrat (SUB), la couche de câblage arrière (BM1) comprenant un premier motif arrière (11a) et un deuxième motif arrière (11b) isolés l'un de l'autre ;
un premier contact arrière (13a) sur le premier motif arrière (11a) ;
un deuxième contact arrière (13b) sur le deuxième motif arrière (11b) ; et
un commutateur de coupure d'alimentation (PG1) sur une face avant (FS) du substrat (SUB), le commutateur de coupure d'alimentation (PG1) étant connecté aux premier et deuxième motifs arrière (11a, 11b),
dans lequel le commutateur de coupure d'alimentation (PG1) comprend :
une première région source/drain (SD1) connectée au premier motif arrière (11a) par l'intermédiaire d'un premier via arrière (12a) et du premier contact arrière (13a), et configurée pour recevoir une première tension d'alimentation (VDDG) provenant du premier motif arrière (11a) ;
une structure de ligne de grille (GT) configurée pour recevoir un signal de commande d'alimentation (PGE) ; et
une deuxième région source/drain (SD2) connectée au deuxième motif arrière (11b) par l'intermédiaire d'un deuxième via arrière (12b) et du deuxième contact arrière (13b), et configurée pour recevoir un signal d'alimentation provenant de la première région source/drain (SD1) sur la base du signal de commande d'alimentation (PGE).

2. Le circuit intégré (10, 20, 20a, 30, 40, 40a, 40b, 50, 50a, 60, 60a, 70, 80) selon la revendication 1, dans lequel, sur la base du signal de commande d'alimentation (PGE) se trouvant à un niveau d'activation, la deuxième région source/drain (SD2) du commutateur de commande d'alimentation (PG1) est configurée pour fournir une deuxième tension d'alimentation (VDD) au deuxième motif arrière (11b) sur la base du signal d'alimentation.

3. Le circuit intégré (10, 20, 20a, 30, 40, 40a, 40b, 50, 50a, 60, 60a, 70, 80) selon la revendication 2, dans lequel la première tension d'alimentation (VDDG) correspond à une tension d'alimentation globale ou à une tension d'alimentation externe, et
dans lequel la deuxième tension d'alimentation (VDD) correspond à une tension d'alimentation virtuelle ou à une tension d'alimentation interne.

4. Le circuit intégré (10, 20, 20a, 30, 40, 40a, 40b, 50, 50a, 60, 60a, 70, 80) selon l'une des revendications 1 à 3, comprenant en outre :
dans lequel le premier via arrière (12a) est situé entre le premier contact arrière (13a) et le premier motif arrière (11a) ; et
dans lequel le deuxième via arrière (12b) est situé entre le deuxième contact arrière (13b) et le deuxième motif arrière (11b).

5. Le circuit intégré (10, 20, 20a, 30, 40, 40a, 40b, 50, 50a, 60, 60a, 70, 80) selon la revendication 1, dans lequel la couche de câblage arrière (BM1) comprend en outre un troisième motif arrière (11c) isolé des premier et deuxième motifs arrière (11a, 11b),
dans lequel le premier motif arrière (11a) et le troisième motif arrière (11c) sont connectés, et
dans lequel la première région source/drain (SD1) du commutateur de coupure d'alimentation (PG1) est configurée pour recevoir la première tension d'alimentation provenant du troisième motif arrière (11c).

6. Le circuit intégré (10, 20, 20a, 30, 40, 40a, 40b, 50, 50a, 60, 60a, 70, 80) selon la revendication 1, dans lequel la couche de câblage arrière (BM1) comprend en outre un troisième motif arrière (11c) espacé des premier et deuxième motifs arrière (11a, 11b),
dans lequel le deuxième motif arrière (11b) et le troisième motif arrière (11c) sont connectés, et
dans lequel le circuit intégré (10, 20, 20a, 30, 40, 40a, 40b, 50, 50a, 60, 60a, 70, 80) comprend en outre une troisième région source/drain (SD3) configurée pour recevoir la deuxième tension d'alimentation à travers le troisième motif arrière (11c).

7. Le circuit intégré (10, 20, 20a, 30, 40, 40a, 40b, 50, 50a, 60, 60a, 70, 80) selon la revendication 1, dans lequel la couche de câblage arrière (BM1) comprend en outre un troisième motif arrière (11c) isolé du deuxième motif arrière (11b),
dans lequel le deuxième motif arrière (11b) et le troisième motif arrière (11c) sont connectés, et
dans lequel le circuit intégré (10, 20, 20a, 30, 40, 40a, 40b, 50, 50a, 60, 60a, 70, 80) comprend en outre une troisième région source/drain (SD3) configurée pour recevoir la deuxième tension d'alimentation à travers le troisième motif arrière (11c).

8. Le circuit intégré (10, 20, 20a, 30, 40, 40a, 40b, 50, 50a, 60, 60a, 70, 80) selon l'une des revendications 1 à 7, comprenant en outre une deuxième couche de câblage arrière (BM2) située sous la couche de câblage arrière (BM1) dans une direction verticale (Z),
dans lequel la deuxième couche de câblage arrière (BM2) comprend :
une première ligne de câblage arrière connectée au premier motif arrière (11a) et configurée pour recevoir la première tension d'alimentation ; et
une deuxième ligne de câblage arrière connectée au deuxième motif arrière (11b) et configurée pour recevoir la deuxième tension d'alimentation.

9. Le circuit intégré (10, 20, 20a, 30, 40, 40a, 40b, 50, 50a, 60, 60a, 70, 80) selon l'une des revendications 1 à 8, dans lequel le premier contact arrière (13a) traverse le substrat (SUB) dans une direction verticale (Z) et est connecté à la première région de source/drain (SD1) du commutateur de coupure d'alimentation (PG1), et
le deuxième contact arrière (13b) traverse le substrat (SUB) dans la direction verticale (Z) et est connecté à la deuxième région source/drain (SD2) du commutateur de coupure d'alimentation (PG1).

10. Le circuit intégré (10, 20, 20a, 30, 40, 40a, 40b, 50, 50a, 60, 60a, 70, 80) selon l'une des revendications 1 à 9, dans lequel le commutateur de coupure d'alimentation (PG1) comprend une pluralité de transistors (TR1-TR3) connectés en parallèle.

11. Le circuit intégré (10, 20, 20a, 30, 40, 40a, 40b, 50, 50a, 60, 60a, 70, 80) selon l'une des revendications 1 à 10, dans lequel :
le premier motif arrière (11a) et le deuxième motif arrière (11b) s'étendent chacun dans une première direction (X) et sont isolés l'un de l'autre dans une deuxième direction qui croise la première direction (X),
le circuit intégré (10, 20, 20a, 30, 40, 40a, 40b, 50, 50a, 60, 60a, 70, 80) comprend un contact (13a-c, 33a, 33b, 63a, 63b, 73a-d, 74a, 74b, 83a-c) sur la face avant (FS) du substrat (SUB), le contact (13a-c, 33a, 33b, 63a, 63b, 73a-d, 74a, 74b, 83a-c) s'étendant dans la deuxième direction (Y), et
la première région de source/drain (SD1) est configurée pour recevoir la première tension d'alimentation provenant du premier motif arrière (1 1a) par l'intermédiaire du contact (13a-c, 33a, 33b, 63a, 63b, 73a-d, 74a, 74b, 83a-c).
